(19)

**Europäisches Patentamt**
**European Patent Office**
**Office européen des brevets**

(11) **EP 4 576 157 A1**

(12) **EUROPEAN PATENT APPLICATION**

(43) Date of publication:
**25.06.2025 Bulletin 2025/26**

(21) Application number: **23218888.8**

(22) Date of filing: **20.12.2023**

(51) International Patent Classification (IPC):
***H01J 37/244*** *(2006.01)* ***H01J 37/28*** *(2006.01)*

(52) Cooperative Patent Classification (CPC):
**H01J 37/244; H01J 37/28;** H01J 2237/2482

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **ASML Netherlands B.V.**
**5500 AH Veldhoven (NL)**

(72) Inventors:
 • **DE LANGEN, Johannes, Cornelis, Jacobus**
  **5500 AH Veldhoven (NL)**
 • **MARTINEZ NEGRETE GASQUE, Diego**
  **5500 AH Veldhoven (NL)**

(74) Representative: **ASML Netherlands B.V.**
**Corporate Intellectual Property**
**P.O. Box 324**
**5500 AH Veldhoven (NL)**

(54) **HIGH-VOLTAGE DISCHARGE DETECTION IN A CHARGED PARTICLE SYSTEM**

(57)    An improved technology for detecting discharge events in charged particle systems is discloses. An electron-optical apparatus for projecting a charged particle beam towards a sample comprises a stage configured to support a sample, a vacuum chamber configured to maintain a vacuum, an electron-optical device configured to generate a charged particle beam and direct the charged particle beam towards the sample, and an optical detection system configured to detect electromagnetic radiation within the apparatus, the optical detection system comprising a sensor and an optical waveguide having a first end positioned so as to detect electromagnetic radiation within the apparatus.

**FIG. 5**

## Description

FIELD

The embodiments provided herein generally relate to a system for detecting high-voltage discharge and related apparatus and methods.

BACKGROUND

When manufacturing semiconductor integrated circuit (IC) chips, undesired pattern defects may occur on a substrate (e.g., wafer) or a mask during the fabrication processes, thereby reducing the yield. Defects may occur as a consequence of, for example, optical effects and incident particles or other processing steps such as etching, deposition or chemical mechanical polishing. Monitoring the extent of the undesired pattern defects is therefore an important process in the manufacture of IC chips. More generally, the assessment (e.g., inspection and/or measurement) of a surface of a substrate, or other object/material, is an important process during and/or after its manufacture.

Pattern assessment systems with a charged particle beam of charged particles have been used to assess objects, for example pattern inspection tools such as to detect pattern defects. The charged particles are often electrons. These systems typically use electron microscopy techniques, such as a scanning electron microscope (SEM). In an example design of SEM, a primary electron beam of electrons at a relatively high energy is targeted with a final deceleration step to land on a target at a relatively low landing energy. The beam of electrons is focused as a probing spot on the target. The interactions between the material structure at the probing spot and the landing electrons from the beam of electrons cause interaction products such as charged particles, referred to as 'signal particles' such as electrons to be emitted from the surface, such as secondary electrons, backscattered electrons or Auger electrons, which together may be referred as signal electrons or more generally signal particles. The generated secondary electrons may be emitted from the material structure of the target.

By scanning the primary electron beam as the probing spot over the target surface, signal electrons can be emitted from the surface of the target. By collecting these emitted signal electrons from the target surface, a pattern inspection tool (or apparatus) may obtain an image-like signal representing characteristics of the material structure of the surface of the target.

Assessment systems generally operate at high voltage, and any contamination of a component of the assessment system or presence of particle on such a component may cause an electrical discharge (or simply discharge) in a discharge event inside such a system. Such electrical discharge events may cause unwanted effects in the systems or even damage to the systems. [

SUMMARY

It is an object of the present disclosure to provide a system and method for detecting a high voltage discharge or a partial discharge in a charged particle apparatus.

In some embodiments, an electron-optical apparatus for projecting a charged particle beam towards a sample is provided. The apparatus comprises a stage configured to support a sample, a vacuum chamber configured to maintain a vacuum, an electron-optical device configured to generate a charged particle beam and direct the charged particle beam towards the sample, and an optical detection system configured to detect electromagnetic radiation within the apparatus, the optical detection system comprising a sensor and an optical waveguide having a first end positioned so as to detect electromagnetic radiation within the apparatus.

In some embodiments, a method of detecting electromagnetic radiation in an electron-optical apparatus for projecting a charged particle beam towards a sample is provided. The electron-optical apparatus comprises a stage configured to support the sample; a vacuum chamber configured to maintain a vacuum; and an electron-optical device configured to generate a charged-particle beam and direct the charged particle beam towards the sample. The method comprises accepting electromagnetic radiation using a first end of an optical waveguide, the first end of the optical waveguide is positioned inside of the apparatus; transmitting the accepted electromagnetic radiation through the optical waveguide from the first end to a sensor; and detect the accepted electromagnetic radiation using the sensor. Wherein the electron-magnetic radiation is indicative of a discharge event within the apparatus.

Advantages of the present disclosure will become apparent from the following description taken in conjunction with the accompanying drawings wherein are set forth, by way of illustration and example, certain embodiments of the present disclosure.

BRIEF DESCRIPTION OF FIGURES

The above and other aspects of the present disclosure will become more apparent from the description of exemplary embodiments, taken in conjunction with the accompanying drawings.

**FIG. 1** is a schematic diagram illustrating an example assessment apparatus, consistent with some embodiments of the present disclosure.
**FIG. 2** is a schematic diagram illustrating an example multi-beam charged particle assessment system that is part of the example electron beam assessment apparatus of **FIG. 1,** consistent with some embodiments of the present disclosure.
**FIG. 3** is a schematic diagram of an example charged particle system comprising a macro collimator and macro scan deflector, consistent with some embodiments of the present disclosure.

**FIG. 4** is a schematic diagram illustrating an example multi-beam charged particle system that is part of the example assessment apparatus of **FIG. 1,** consistent with some embodiments of the present disclosure.

**FIG. 5** is a schematic cross-sectional diagram of an optical waveguide, for example along a length of the optical waveguide, consistent with some embodiments of the present disclosure.

**FIG. 6** is a schematic diagram of a cross sectional view of an optical waveguide, for example along the length of the optical waveguide, mounted on a vacuum wall of a charged particle system, consistent with some embodiments of the present disclosure.

**FIG. 7** is a schematic diagram of a plurality of optical waveguides installed within a charged particle system via a vacuum feedthrough, consistent with some embodiments of the present disclosure.

**FIG. 8** is a schematic diagram of a plurality of optical waveguides installed within a charged particle system, consistent with some embodiments of the present disclosure.

**FIG. 9** is a schematic diagram of a plurality of optical waveguides installed on a plate across a beam path, consistent with some embodiments of the present disclosure.

**FIG. 10** is a schematic diagram of an alternative example charged particle-optical device that is part of the example assessment apparatus of **FIG. 1,** consistent with some embodiments of the present disclosure.

**FIG. 11** is a schematic diagram of an example multi-beam charged particle system, consistent with some embodiments of the present disclosure.

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the disclosure. Instead, they are merely examples of apparatuses and methods consistent with aspects related to the disclosure as recited in the appended claims.

DETAILED DESCRIPTION

The reduction of the physical size of devices, and enhancement of the computing power of electronic devices, may be accomplished by significantly increasing the packing density of circuit components such as transistors, capacitors, diodes, etc. on an IC chip. This has been enabled by increased resolution enabling yet smaller structures to be made. Semiconductor IC manufacturing is a complex and time-consuming process, with hundreds of individual steps. An error in any step of the process of manufacturing an IC chip has the potential to adversely affect the functioning of the final product. Just one defect could cause device failure. It is desirable to improve the overall yield of the process. For example, to obtain a 75% yield for a 50-step process (where a step may indicate the number of layers formed on a wafer), each individual step must have a yield greater than 99.4%. If an individual step has a yield of 95%, the overall process yield would be as low as 7-8%.

Maintaining a high substrate (i.e., wafer) throughput, defined as the number of substrates processed per hour, is also desirable. High process yield and high substrate throughput may be impacted by the presence of a defect. This is especially true if operator intervention is required for reviewing the defects. High throughput detection and identification of micro and nano-scale defects by assessment systems (such as a SEM) is desirable for maintaining high yield and low cost for IC chips.

A scanning electron microscope comprises a scanning device and a detector apparatus. The scanning device comprises an illumination apparatus that comprises an electron source, for generating primary electrons, and a projection apparatus for scanning a target, such as a substrate, with one or more focused beams of primary electrons. The primary electrons interact with the target and generate interaction products, such as signal particles e.g., secondary electrons and/or backscattered electrons. Secondary electrons may be considered to have an energy of up to 50eV. Backscatter electrons, although having an energy spectrum from substantially zero to the energy of the maximum of the charged particle device, are conventionally set to electrons (or signal electrons) having an energy exceeding 50eV. The detection apparatus captures the signal particles (e.g., secondary electrons and/or backscattered electrons) from the target as the target is scanned so that the scanning electron microscope may create an image of the scanned area of the target. A design of charged particle-optical apparatus embodying these scanning electron microscope features may have a single beam. For higher throughput such as for assessment, some designs of apparatus use multiple focused beams, i.e., a multi-beam, of primary electrons. The component beams of the multi-beam may be referred to as sub-beams or beamlets. A multi-beam may scan different parts of a target simultaneously. A multi-beam assessment apparatus may therefore assess a target much quicker, e.g., by moving the target at a higher speed, than a single-beam assessment apparatus.

An implementation of a known multi-beam assessment apparatus is described below.

The Figures are schematic. Relative dimensions of components in drawings are therefore exaggerated for clarity. Within the following description of drawings the same or like reference numbers refer to the same or like components or entities, and only the differences with respect to the individual embodiments are described. While the description and drawings are directed to an electron-optical apparatus, it is appreciated that the embodiments are not used to limit the present disclosure to specific charged particles. References to electrons, and items referred with reference to electrons, throughout the present disclosure may therefore be more generally be considered to be references to charged particles, and items referred to in reference to charged particles, with the charged particles not necessarily being electrons.

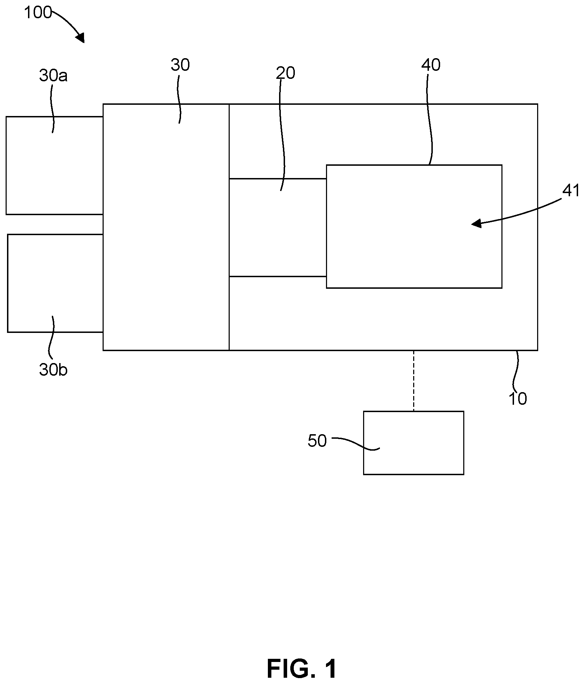

Reference is now made to **FIG. 1,** which is a schematic diagram illustrating an example assessment apparatus 100, e.g., an inspection apparatus. The assessment apparatus 100 of **FIG. 1** includes a vacuum chamber 10, a load lock chamber 20, a charged particle-optical apparatus 40, an equipment front end module (EFEM) 30 and a controller 50. The charged particle device 41 may be within the vacuum chamber 10. The electron-optical apparatus 40 may comprise a charged particle device 41 (also known as an electron-optical device, an electron beam device or an electron beam device) and a motorized or actuated stage.

The EFEM 30 includes a first loading port 30a and a second loading port 30b. The EFEM 30 may include additional loading port(s). The first loading port 30a and second loading port 30b may, for example, receive substrate front opening unified pods (FOUPs) that contain substrates (e.g., semiconductor substrates or substrates made of other material(s)) or targets to be assessed (substrates, wafers, and samples are collectively referred to as "targets" hereafter). One or more robot arms (not shown) in EFEM 30 transport the targets to load lock chamber 20.

The load lock chamber 20 is used to remove the gas around a target. The load lock chamber 20 may be connected to a load lock vacuum pump system (not shown), which removes gas particles in the load lock chamber 20. The operation of the load lock vacuum pump system enables the load lock chamber to reach a first pressure below the atmospheric pressure. The main chamber 10 is connected to a main chamber vacuum pump system (not shown). The main chamber vacuum pump system removes gas molecules in the main chamber 10 so that the pressure around the target reaches a second pressure lower than the first pressure. After reaching the second pressure, the target is transported to the charged particle device 41 by which it may be assessed. A charged particle device 41 may comprise either a single beam or a multi-beam charged particle-optical apparatus.

The controller 50 is electronically connected to the charged particle system 40. The controller 50 may be a processor (such as a computer) configured to control the charged particle beam assessment apparatus 100. A processor may be an electronic device capable of manipulating or processing information. For example, the processor may include any combination of any number of a central processing unit (or "CPU"), a graphics processing unit (or "GPU"), an optical processor, a programmable logic controllers, a microcontroller, a microprocessor, a digital signal processor, an intellectual property (IP) core, a Programmable Logic Array (PLA), a Programmable Array Logic (PAL), a Generic Array Logic (GAL), a Complex Programmable Logic Device (CPLD), a Field-Programmable Gate Array (FPGA), a System On Chip (SoC), an Application-Specific Integrated Circuit (ASIC), a neural processing unit (NPU), and any other type of circuit capable of data processing. The processor may also be a virtual processor that includes one or more processors distributed across multiple machines or devices coupled via a network.

The controller 50 may also include a processing circuitry configured to execute various signal and image processing functions. While the controller 50 is shown in **FIG. 1** as being outside of the structure that includes the main chamber 10, the load lock chamber 20, and the EFEM 30, it is appreciated that the controller 50 may be part of the structure. The controller 50 may be located in one of the component elements of the charged particle beam assessment apparatus 100 or it may be distributed over at least two of the component elements. While the present disclosure provides examples of main chamber 10 housing an electron beam assessment apparatus, it should be noted that aspects of the disclosure in their broadest sense are not limited to a chamber housing a charged particle-optical device 41. Rather, it is appreciated that the foregoing principles may also be applied to other apparatuses and other arrangements of apparatus that operate under the second pressure.

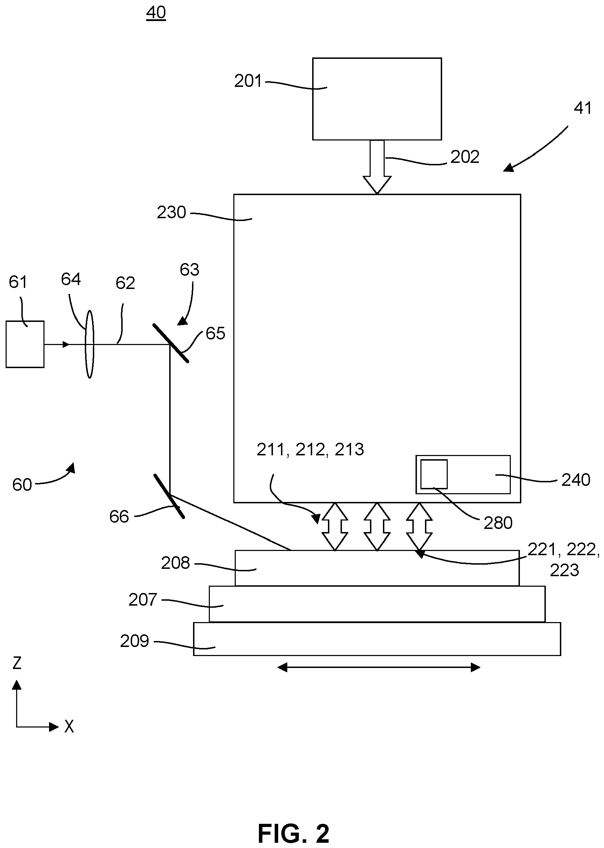

Reference is now made to **FIG. 2,** which is a schematic diagram illustrating an example charged particle system 40 including a multi-beam charged particle device 41 that is part of the example charged particle beam assessment apparatus 100 of **FIG. 1.** The multi-beam charged particle device 41 comprises an electron source 201 and a projection apparatus 230. The charged particle system 40 further comprises an actuated stage 209 and a sample holder 207. The sample holder may have a holding surface (not depicted) for supporting and holding the sample. Thus, the sample holder 207 may be configured to support the sample 208. Such a holding surface may be an electrostatic clamp operable to hold the sample during operation of the charged particle device 41 e.g. assessment such as measurement or inspection of at least part of the sample. The holding surface may be recessed into sample holder, for example a surface of the sample holder orientated to face the charged particle device 41. The electron source 201 and projection apparatus 230 may together be referred to as the charged particle device 41. The sample holder 207 is supported by actuated stage 209 so as to hold a sample 208 (e.g., a substrate or a mask) for assessment. The multi-beam charged particle device 41 further comprises a detector 240 (e.g., an electron detection device).

The electron source 201 may comprise a cathode (not shown) and an extractor or anode (not shown). During operation, the electron source 201 is configured to emit electrons as primary electrons from the cathode. The primary electrons are extracted or accelerated by the extractor and/or the anode to form a primary electron beam 202.

The projection apparatus 230 is configured to convert the primary electron beam 202 into a plurality of sub-beams 211, 212, 213 and to direct each sub-beam onto the sample 208. Although three sub-beams are illustrated for simplicity, there may be many tens, many hundreds or many thousands of sub-beams. The sub-beams may be referred to as beamlets, beams of the beam grid, etc.

The controller 50 may be connected to various parts of the charged particle beam assessment apparatus 100 of **FIG. 1,** such as the electron source 201, the detector 240, the projection apparatus 230, and the actuated stage 209. The controller 50 may perform various image and signal processing functions. The controller 50 may also generate various control signals to govern operations of the charged particle beam assessment apparatus, including the charged particle multi-beam apparatus.

The projection apparatus 230 may be configured to focus sub-beams 211, 212, and 213 onto a sample 208 for assessment and may form three probe spots 221, 222, and 223 on the surface of sample 208. The projection apparatus 230 may be configured to deflect the primary sub-beams 211, 212, and 213 to scan the probe spots 221, 222, and 223 across individual scanning areas in a section of the surface of the sample 208. Such scanning may be controlled by the controller 50 to cooperate with a simultaneous scanning movement of the actuated stage 209. In response to incidence of the primary sub-beams 211, 212, and 213 on the probe spots 221, 222, and 223 on the sample 208, signal particles e.g., signal electrons are generated from the sample 208, which include secondary electrons and backscattered electrons. The secondary electrons typically have electron energy $\leq 50$ eV. Actual secondary electrons can have an energy of less than 5 eV, but anything beneath 50 eV is generally treated as a secondary electron. Backscattered electrons typically have electron energy between 0 eV and the landing energy of the primary sub-beams 211, 212, and 213. As electrons detected with an energy of less than 50 eV is generally treated as a secondary electron, a proportion of the actual backscatter electrons will be counted as secondary electrons.

The detector 240 is configured to detect signal particles such as secondary electrons and/or backscattered electrons and to generate corresponding signals, which are sent to a signal processing system 280, e.g., to construct images of the corresponding scanned areas of sample 208. The detector 240 may be incorporated into the projection apparatus 230.

The signal processing system 280, which may be part of the controller 50, may comprise a circuit (not shown) configured to process signals from the detector 240 so as to form an image. The signal processing system 280 could otherwise be referred to as a detection signal processing system. The signal processing system may be incorporated into a component of the multi-beam charged particle system 40 such as the detector 240 (as shown in **FIG. 2).** However, the signal processing system 280 may be incorporated into any components of the assessment apparatus 100 or multi-beam charged particle system 40, such as, as part of the projection apparatus 230 or the controller 50. The signal processing system 280 may include an image acquirer (not shown) and a storage device (not shown). For example, the signal processing system may comprise a processor, computer, server, mainframe host, terminals, personal computer, any kind of mobile computing devices, and the like, or a combination thereof. The image acquirer may comprise at least part of the processing function of the controller. Thus, the image acquirer may comprise at least one or more processors. The image acquirer may be communicatively coupled to the detector 240 permitting signal communication, such as an electrical conductor, optical fiber cable, portable storage media, IR, Bluetooth, internet, wireless network, wireless radio, among others, or a combination thereof. The image acquirer may receive a signal from the detector 240, may process the data comprised in the signal and may construct an image therefrom. The image acquirer may thus acquire images of the sample 208. The image acquirer may also perform various post-processing functions, such as generating contours, superimposing indicators on an acquired image, and the like. The image acquirer may be configured to perform adjustments of brightness and contrast, etc. of acquired images. The storage may be a storage medium such as a hard disk, flash drive, cloud storage, random access memory (RAM), other types of computer readable memory, and the like. The storage may be coupled with the image acquirer and may be used for saving scanned raw image data as original images, and post-processed images.

The signal processing system 280 may include measurement circuitry (e.g., analog-to-digital converters) to obtain a distribution of the detected secondary electrons. The electron distribution data, collected during a detection time window, may be used in combination with corresponding scan path data of each of primary sub-beams 211, 212, and 213 incident on the sample surface, to reconstruct images of the sample structures under assessment. The reconstructed images may be used to reveal various features of the internal or external structures of the sample 208. The reconstructed images may thereby be used to reveal any defects that may exist in the sample.

As mentioned, the controller 50 may control the actuated stage 209 to move sample 208 during assessment, e.g., inspection, of the sample 208. The controller 50 may enable the actuated stage 209 to move the sample 208 in a direction, preferably continuously, for example at a constant speed, at least during sample assessment. The controller 50 may control movement of the actuated stage 209 so that it changes the speed of the movement of the sample 208 dependent on various parameters. For example, the controller 50 may control the stage speed (including its direction) depending on the characteristics of the assessment steps of scanning process.

Known multi-beam systems, such as the charged particle system 40 and charged particle beam assessment apparatus 100 described above, are disclosed in US2020118784, US20200203116, US 2019/0259570 and US2019/0259564 all of which are hereby incorporated by reference.

As shown in FIG. 2, in an example, the charged particle system 40 has a single charged particle device 41 and optionally comprises a projection assembly 60. The projection assembly 60 may be a module and may be referred to as an ACC module. The projection assembly 60 is arranged to direct a light beam 62 such that the light beam 62 enters between the charged particle device 41 and the sample 208.

When the electron beam scans the sample 208, charges may be accumulated on the sample 208 due to large beam current, which may affect the quality of the image. To regulate the accumulated charges on the sample, the projection assembly 60 may be employed to illuminate the light beam 62 on the sample 208, so as to control the accumulated charges due to effects such as photoconductivity, photoelectric, or thermal effects.

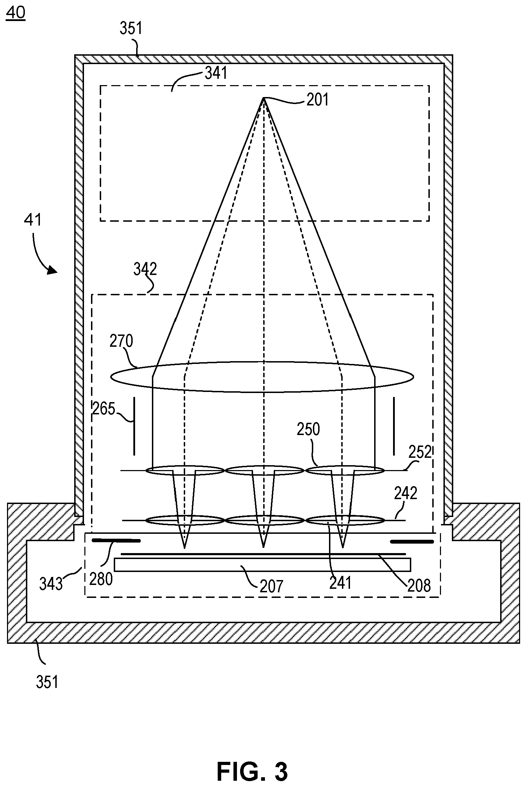

Components of a charged particle system 40, which may be used in some embodiments of the present disclosure are described below in relation to each and all of **FIGs. 3, 4, 10,** and **11,** which are schematic diagrams of a charged particle system 40. The charged particle system 40 of the arrangements shown in these figures may correspond to the charged particle system 40 (which may also be referred to as an apparatus or a tool) mentioned above.

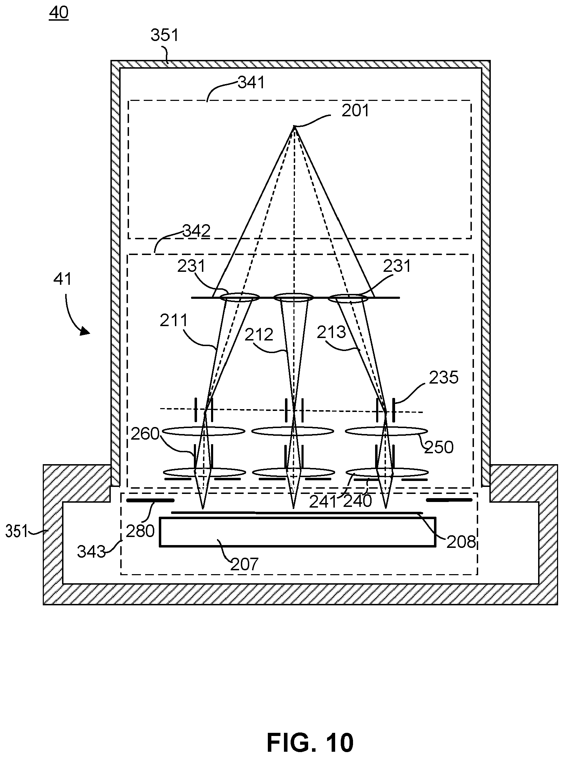

Considering the arrangement as shown in **FIG. 10** the electron source 201 directs electrons toward an array of condenser lenses 231 (otherwise referred to as a condenser lens array). The electron source 201 is desirably a high brightness emitter arranged to operate within an optimized electron-optical performance range that is a compromise between brightness and total emission current (such a compromise may be considered to be a 'good' compromise). The electron source emits a source beam. In this disclosure, a source section 341 of charged particle system 40 comprise all surfaces of all components such as the electron optical components of and related to the electron source 201 including an emitter, anode or extractor, electrodes, lenses, etc. The surfaces of the components include proximate regions of the wall 351 of the vacuum chamber.

There may be many tens, many hundreds or many thousands, or even tens of thousands of condenser lenses 231. The condenser lenses 231 may comprise multi-electrode lenses and have a construction based on EP1602121A1, which is hereby incorporated by reference in particular to the disclosure of a lens array to split a source beam into a plurality of sub-beams. A most upbeam plate, which may be referred to as beam limiting aperture array, and which may be the most upbeam plate of the condenser lens array, may generate the plurality of beams. The array condenser lenses (which may comprise the beam limiting aperture array) may provide a lens for each sub-beam. The array of condenser lenses 231 may take the form of at least two plates, acting as electrodes, with an aperture in each plate aligned with each other and corresponding to the location of a sub-beam. At least two of the plates are maintained during operation at different potentials to achieve the desired lensing effect.

In an arrangement the array of condenser lenses 231 is formed of three plate arrays in which charged particles have the same energy as they enter and leave each lens, which arrangement may be referred to as an Einzel lens. Thus, dispersion only occurs within the Einzel lens itself (between entry and exit electrodes of the lens), thereby limiting off-axis chromatic aberrations. When the thickness of the condenser lenses is low, e.g., a few mm, such aberrations have a small or negligible effect.

Each condenser lens 231 in the array directs electrons into a respective sub-beam 211, 212, 213, which is focused at a respective intermediate focus downbeam of the condenser lens array. The sub-beams diverge with respect to each other. In some embodiments, collimators such as deflectors 235 are provided at the intermediate focuses. The collimators are positioned in the sub-beam paths at, or at least around, the position of the corresponding intermediate points of focus. The collimators are positioned in or close to the sub-beam paths at the intermediate image plane of the associated sub-beam. The collimators are configured to operate on the respective sub-beams 211, 212, 213. The collimators are configured to bend the respective sub-beam 211, 212, 213 by an amount effective to ensure that the principal ray (which may also be referred to as the beam axis) is incident on the sample 208 substantially normally (i.e., at substantially 90° to the nominal surface of the sample). The collimators (e.g., deflectors 235) may also be referred to as collimator deflectors. The deflectors 235 in effect collimate the paths of the sub-beams so that before the deflectors, the sub-beam paths with respect to each other are diverging. Downbeam of the collimators the sub-beam paths are substantially parallel with respect to each other, i.e., substantially collimated. Suitable collimators are deflectors disclosed in EP Application 20156253.5 filed on 7 February 2020, which is hereby incorporated by reference with respect to the application of the deflectors to a multi-beam array. In some embodiments of the arrangement, the collimator may comprise a macro collimator, instead of, or in addition to the deflectors 235. The macro-collimator may be electrostatic for example as two more planar plates with a single aperture.

Below (i.e., downbeam or further from source 201) the deflectors 235 there is a control lens array 250. The sub-beams 211, 212, 213 having passed through the deflectors 235 are substantially parallel on entry to the control lens array 250. The control lenses pre-focus the sub-beams (e.g., apply a focusing action to the sub-beams prior to the sub-beams reaching an objective lens array 241). The pre-focusing may reduce divergence of the sub-beams or increase a rate of convergence of the sub-beams. The control lens array 250 and the objective lens array 241 operate together to provide a combined focal length. Combined operation without an intermediate focus may reduce the risk of aberrations. In some embodiments the control lenses of the control lens array may be considered to be part of the objective lenses of the objective lens array. The electrode plates of the control lens array may be considered electron-optically to be additional electrode plates of the objective lens array.

It is desirable to use the control lens array 250 to determine the landing energy. However, it is possible to use in addition the objective lens array 241 to control the landing energy. In such a case, a potential difference over the objective lens is changed when a different landing energy is selected.

The control lens array 250 comprises a plurality of control lenses. Each control lens comprises at least two electrodes (e.g., two or three electrodes) connected to respective potential sources. The control lens array 250 may comprise two or more (e.g., three) plate electrode arrays connected to respective potential sources. The control lens array 250 is associated with the objective lens array 241 (e.g., the two arrays are positioned close to each other and/or mechanically connected to each other and/or controlled together as a unit). Each control lens may be associated with a respective objective lens. The control lens array 250 is positioned upbeam of the objective lens array 241.

The control lens array 250 comprises a control lens for each sub-beam 211, 212, 213. A function of the control lens array 250 is to optimize the beam opening angle with respect to the demagnification of the beam and/or to control the beam energy delivered to the objective lens array 241 which directs the sub-beams 211, 212, 213 onto the sample 208. The objective lens array 241 may be positioned at or near the base of the charged particle device 41. The control lens array 250 is optional, but is preferred for optimizing a sub-beam upbeam of the objective lens array. In an arrangement the control lens array 250 may be considered to be part of the objective lens array. The plates of the control lens array may be considered to be additional plates of the objective lens array. Within an objective lens array meeting this definition the function of the control lens array may be a function of the objective lens array in addition to the functions of the objective lens array herein described.

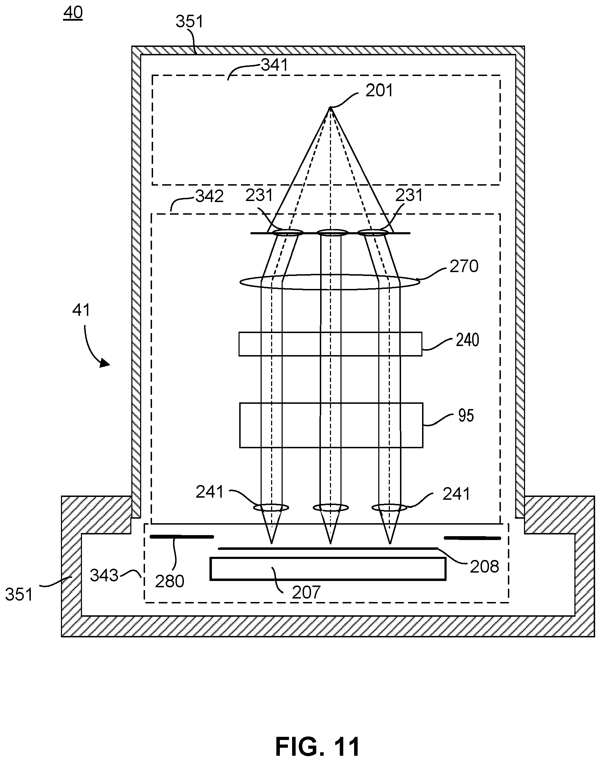

For ease of illustration, lens arrays are depicted schematically herein by arrays of oval shapes (as shown in **FIG. 10** and for that matter **FIGs 3** and **11).** Each oval shape represents one of the lenses in the lens array. The oval shape is used by convention to represent a lens, by analogy to the biconvex form often adopted in optical lenses. In the context of charged-particle arrangements such as those discussed herein, it will be understood however that lens arrays will typically operate electrostatically and so may not require any physical elements adopting a biconvex shape. Lens arrays may instead comprise multiple plates with apertures.

An array of scan deflectors 260 may be provided between the control lens array 250 and the array of objective lenses 234. The array of scan deflectors 260 comprises a scan deflector for each sub-beam 211, 212, 213. Each scan deflector is configured to deflect the respective sub-beam 211, 212, 213 in one or two directions so as to scan the sub beam across the sample 208 in one or two directions.

In some embodiments, charged particle system 40 may further comprise a plate 280 proximate to sample 208, which may be referred to as a shielding plate 280, as shown in **FIG. 10.** In some embodiments, shielding plate 280 is configured to shield the sample 208 from stray potentials and to ensure a consistent electrostatic field exists above the sample for example when the sample is set to a potential difference of large magnitude relative to ground for the charged particle apparatus 40. The shielding plate 280 may be set to a similar potential as the sample. The sample may be at or close to ground in which case the shielding plate is at or close to ground. In such an arrangement the shielding plate may not be present. The sample may be set at tens of kilovolts so that the shielding plate is set at or about tens of kilovolts. The shielding plate 280 may help suppress discharge events from the sample during operation for example by eliminating any fields between the shielding plate and the sample 208. In some embodiments, the shielding plate 280 additionally tune electrostatic field strength on sample 208 without changing landing energy of the beam incident on sample 208. Such a shielding plate 280 may act as a retardant or extractor by applying a bias by tuning the potential applied to the shielding plate 280.

In this disclosure, an electron column section 342 of charged particle system 40 comprises an electron-optical column including all components such as electron optical components along the path of the charged particles for example in the source beam from electron source 201 to sample 208 as primary beams. Similarly, a stage section 343 of charged particle system 40 comprises sample 208 and sample holder 207, which is placed below the electron-optical column and the shielding plate 280. As shown in **FIG. 10,** shielding plate 280 can be placed around the down beam end of the electron-optical column and to face the sample holder 207 and the sample 208 (which supported by the sample holder 207). Both the electron column section 342 and the stage section 343 comprise, as components, respective regions of an inner surface of the wall 351 of the vacuum chamber. In some embodiments, discharge events can occur between the inner surface of the wall 351 and other respective components in the electron column section 342 and the stage section 343.

In the example of **FIG. 3,** the charged particle system 40 comprises a source 201. Features, functions, benefits, and advantages of the present disclosure described in reference to earlier embodiments apply to some embodiments referring to **FIG. 3** unless statements are made to the contrary. The source 201 provides a beam of charged particles (e.g., electrons). The multibeam focused on the sample 208 is derived from the beam provided by the source 201. Sub-beams may be derived from the beam, for example, using a beam limiter defining an array of beam-limiting apertures. For example, as shown in **FIG. 3** in an example the charged particle device 41 comprises an upper beam limiter 252 that defines an array of beam-limiting apertures. The upper beam limiter 252 may comprise a plate (which may be a plate-like body) having a plurality of apertures.

The source 201 is desirably a high brightness thermal field emitter with a good compromise between brightness and total emission current. In the example shown, a collimator is provided upbeam of the objective lens array assembly. The collimator may comprise a macro collimator 270. The macro collimator 270 acts on the beam from the source 201 before the beam has been split into a multi-beam. The macro collimator 270 bends respective portions of the beam by an amount effective to ensure that a beam axis of each of the subbeams derived from the beam is incident on the sample 208 substantially normally (i.e., at substantially 90° to the nominal surface of the sample 208). The macro collimator 270 applies a macroscopic collimation to the beam. The macro collimator 270 may thus act on all of the beam rather than comprising an array of collimator elements that are each configured to act on a different individual portion of the beam. The macro collimator 270 may comprise a magnetic lens or magnetic lens arrangement comprising a plurality of magnetic lens sub-units (e.g., a plurality of electromagnets forming a multi-pole arrangement). Alternatively or additionally, the macro-collimator may be at least partially implemented electrostatically, for example wholly electrostatically. The macro-collimator may comprise an electrostatic lens or electrostatic lens arrangement comprising a plurality of electrostatic lens sub-units. The macro collimator 270 may use a combination of magnetic and electrostatic lenses. Desirably, the macro collimator 270 uses only electrostatic lenses.

In the example of **FIG. 3** a macro scan deflector 265 is provided to cause sub-beams to be scanned over the sample 208. The macro scan deflector 265 deflects respective portions of the beam to cause the sub-beams to be scanned over the sample 208. In some embodiments, the macro scan deflector 256 comprises a macroscopic multi-pole deflector, for example with 8 poles or more. The macro-scan deflector may be electrostatic or magnetic. The deflection is such as to cause sub-beams derived from the beam to be scanned across the sample 208 in one direction (e.g., parallel to a single axis, such as an X axis) or in two directions (e.g., relative to two nonparallel axes, such as X and Y axes). The macro scan deflector 265 acts macroscopically on all of the beam rather than comprising an array of deflector elements that are each configured to act on a different individual portion of the beam. In the example shown, the macro scan deflector 265 is provided between the macro collimator 270 and the control lens array 250.

In some embodiments, for example variations of the arrangements shown in and described with reference to **FIG. 3,** both the macro scan deflector 265 and the scan-deflector array 260 are provided. In such an arrangement, the scanning of the sub-beams over the sample surface may be achieved by controlling the macro scan deflector and the scan-deflector array 260 together, preferably in synchronization. A variation may comprise both the macro collimator 270 and a collimator array, distributing the collimation action through the column. In a variation the scan deflector function may be achieved using a scan deflector array with a deflector for one or more sub-beams of the plurality of sub-beams. Such a scan deflector array may be between a control lens array 250 and an objective lens array 241. In a variation the collimating function may be achieved using a collimator array comprising collimating elements for operating on a different sub-beam of the plurality of beams. Such a collimating element may be a deflector. The collimator array may be associated with the control lens array, for example upbeam of a control lens array. In some embodiments, charged particle system 40 can comprise a plurality of charged particle devices each with such a collimator array and a scan deflector array. That is the functionality of each of the charged particle devices with the collimator array and the scan deflector array may correspond to the functionality of the charged particle device shown in and described with reference to **FIG. 3,** although the macro elements of the collimator and scan deflector are present as a collimator array and scan deflector array instead of macro components.

In some embodiments both a macro scan deflector and a scan-deflector array are provided. In such an arrangement, the scanning of the sub-beams over the sample surface may be achieved by controlling the macro scan deflector and the scan-deflector array together, preferably in synchronization.

The objective lens array assembly may further comprise a beam shaping limiter 242. The beam shaping limiter 242 defines an array of beam-limiting apertures. In an arrangement, the beam shaping limiter 242 is structurally integrated with an electrode of the objective lens array 241. Desirably, the beam shaping limiter 242 is positioned in a region of low electrostatic field strength. Each of the beam-limiting apertures is aligned with a corresponding objective lens in the objective lens array 241.

The electron-optical system of **FIG. 3** further comprises a detector (not shown), for example detector 240 as described below in relation to **FIG. 10** (as described further below), desirably the detector may be a detector array.

As shown in **FIG. 3** the charged particle system 40 comprises a vacuum system. In some embodiments, the vacuum system comprises one or more vacuum chambers. The chambers may be defined by the interior surfaces of exterior walls 351 and interior walls (not shown) of the vacuum system. In some embodiments, sample 208 on a sample holder or support may be included within a different chamber from the source 201 or an electron-optical column of charged particle system 40. In some embodiments, the source 201 may be provided in a separate chamber from the electron-optical column of the charged particle system 40. While **FIG. 3** does not illustrate interior walls, it will be appreciated that the vacuum system may have any number of vacuum chambers or having interior walls to divide the vacuum system into separate chambers. In some embodiments, the condenser lens may be disposed within one chamber and the collimator deflectors may be disposed within an adjacent chamber. The control lens array 250 and charge detector 240 may be disposed within the same chamber.

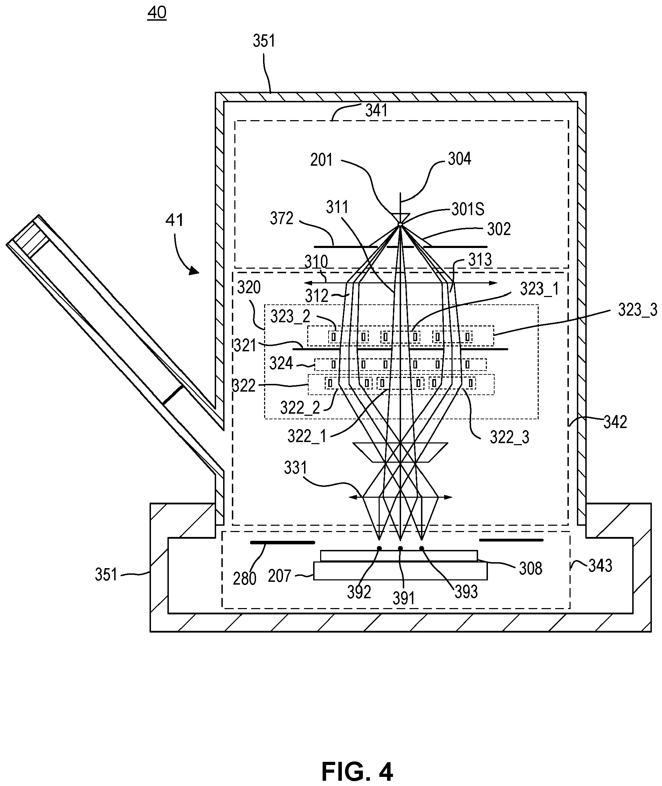

Reference is now made to **FIG. 4,** which is a schematic diagram of an example multi-beam charged particle system 40 of an assessment apparatus, e.g., the assessment apparatus 100 of **FIG. 1.** Features of the earlier described embodiments are the same, unless stated to the contrary. Features, functions, benefits and advantages of the present disclosure described in reference to earlier embodiments apply to some embodiments referring to **FIG. 4** unless statements are made to the contrary. Similarly features, benefits function and advantages described with reference to some embodiments described with reference to **FIG. 4,** unless stated to the contrary, apply to the earlier mentioned embodiments.

As depicted, the charged particle device 41 may comprise an electron source 201, a beam former array 372 (also known as a gun aperture plate, a coulomb aperture array or a pre-sub-beam-forming aperture array), a condenser lens 310, a source converter (or micro-optical array) 320, an objective lens 331, and a target 308. In some embodiments the condenser lens 310 is magnetic. The target 308 may be supported by a support 207 on a stage. The stage may be motorized. The stage moves so that the target 308 is scanned by the incident electrons. The electron source 201, the beam former array 372, the condenser lens 310 may be the components of an illumination apparatus comprised by the charged particle-optical device 41. The source converter 320 (also known as a source conversion unit), described in more detail below, and the objective lens 331 may be the components of a projection apparatus comprised by the charged particle-optical device 41.

The electron source 201, the beam former array 372, the condenser lens 310, the source converter 320, and the objective lens 331 are aligned with a primary electron-optical axis 304 of the charged particle-optical device 41. The electron source 201 may generate a primary beam 302 generally along the electron-optical axis 304 and with a source crossover (virtual or real) 301S. During operation, the electron source 201 is configured to emit electrons. The electrons are extracted or accelerated by an extractor and/or an anode to form the primary beam 302.

The beam former array 372 cuts the peripheral electrons of primary electron beam 302 to reduce a consequential Coulomb effect. The primary-electron beam 302 may be trimmed into a specified number of sub-beams, such as three sub-beams 311, 312 and 313, by the beam former array 372. It should be understood that the description is intended to apply to a charged particle device 41 with any number of sub-beams such as one, two or more than three. The beam former array 372, in operation, is configured to block off peripheral electrons to reduce the Coulomb effect.

The source converter 320 is configured to convert the beam (including sub-beams if present) transmitted by the beam former array 372 into the sub-beams that are projected towards the target 308. In some embodiments the source converter is a unit. Alternatively, the term source converter may be used simply as a collective term for the group of components that form the beamlets from the sub-beams.

As shown in **FIG. 4,** in an example the charged particle device 41 comprises a beam-limiting aperture array 321 with an aperture pattern (i.e., apertures arranged in a formation) configured to define the outer dimensions of the beamlets (or sub-beams) projected towards the target 308. In some embodiments the beam-limiting aperture array 321 is part of the source converter 320. In some embodiments the beam-limiting aperture array 321 is part of the system upbeam of the main device. In some embodiments, the beam-limiting aperture array 321 divides one or more of the sub-beams 311, 312, 313 into beamlets such that the number of beamlets projected towards the target 308 is greater than the number of sub-beams transmitted through the beam former array 372. In some embodiments, the beam-limiting aperture array 321 keeps the number of the sub-beams incident on the beam-limiting aperture array 321, in which case the number of sub-beams may equal the number of beamlets projected towards the target 308.

As shown in **FIG. 4,** in an example the charged particle device 41 comprises a pre-bending deflector array 323 with pre-bending deflectors 323_1, 323_2, and 323_3 to bend the sub-beams 311, 312, and 313 respectively. The pre-bending deflectors 323_1, 323_2, and 323_3 may bend the path of the sub-beams 311, 312, and 313 onto the beam-limiting aperture array 321.

The charged particle device 41 may also include an image-forming element array 322 with image-forming deflectors 322_1, 322_2, and 322_3. There is a respective deflector 322_1, 322_2, and 322_3 associated with the path of each beamlet. The deflectors 322_1, 322_2, and 322_3 are configured to deflect the paths of the beamlets towards the electron-optical axis 304. The deflected beamlets form virtual images (not shown) of source crossover 301. In the current embodiment, these virtual images are projected onto the target 308 by the objective lens 331 and form probe spots 391, 392, 393 thereon. The charged particle device 41 may also include an aberration compensator array 324 configured to compensate aberrations that may be present in each of the sub-beams. In some embodiments the aberration compensator array 324 comprises a lens configured to operate on a respective beamlet. The lens may take the form or an array of lenses. The lenses in the array may operate on a different beamlet of the multi-beam. The aberration compensator array 324 may, for example, include a field curvature compensator array (not shown) for example with micro-lenses. The field curvature compensator and micro-lenses may, for example, be configured to compensate the individual sub-beams for field curvature aberrations evident in the probe spots, 391, 392, and 393. The aberration compensator array 324 may include an astigmatism compensator array (not shown) with micro-stigmators. The micro-stigmators may, for example, be controlled to operate on the sub-beams to compensate astigmatism aberrations that are otherwise present in the probe spots, 391, 392, and 393.

The image-forming element array 322, the aberration compensator array 324, and the pre-bending deflector array 323 may comprise multiple layers of sub-beam manipulating devices, some of which may be in the form of arrays, for example: micro-deflectors, micro-lenses, or micro-stigmators. Beam paths may be manipulated rotationally. Rotational corrections may be applied by a magnetic lens. Rotational corrections may additionally, or alternatively, be achieved by an existing magnetic lens such as the condenser lens arrangement.

The objective lens 331 focuses the beamlets onto the surface of the target 308, i.e., it projects the three virtual images onto the target surface. The three images formed by three sub-beams 311 to 313 on the target surface form three probe spots 391, 392 and 393 thereon. In some embodiments the deflection angles of sub-beams 311 to 313 are adjusted to pass through or approach the front focal point of objective lens 331 to reduce or limit the off-axis aberrations of three probe spots 391 to 393. In an arrangement, the objective lens 331 is magnetic. Although three beamlets are mentioned, this is by way of example only. There may be any number of beamlets.

In some embodiments, a beam separator (not shown) is provided. The beam separator may be downbeam of the source converter 320. The beam separator may be, for example, a Wien filter comprising an electrostatic dipole field and a magnetic dipole field. The beam separator may be upbeam of the objective lens 331. In operation, the beam separator may be configured to exert an electrostatic force by electrostatic dipole field on individual electrons of sub-beams. In some embodiments, the electrostatic force is equal in magnitude but opposite in direction to the magnetic force exerted by the magnetic dipole field of beam separator on the individual primary electrons of the sub-beams. The sub-beams may therefore pass at least substantially straight through the beam separator with at least substantially zero deflection angles. The direction of the magnetic force depends on the direction of motion of the electrons while the direction of the electrostatic force does not depend on the direction of motion of the electrons. So, because the secondary electrons and backscattered electrons (or signal electrons) generally move in an opposite direction compared to the primary electrons, the magnetic force exerted on the secondary electrons and backscattered electrons (or signal particles) will no longer cancel the electrostatic force and as a result the secondary electrons and backscattered electrons moving through the beam separator will be deflected away from the electron-optical axis 304.

In some embodiments, a secondary device (not shown) is provided comprising detection elements for detecting corresponding secondary charged particle beams. On incidence of secondary beams with the detection elements, the elements may generate corresponding intensity signal outputs. The outputs may be directed to an image processing system (e.g., controller 50). Each detection element may comprise an array, which may be in the form of a grid. The array may have one or more pixels; each pixel may correspond to an element of the array. The intensity signal output of a detection element may be a sum of signals generated by all the pixels within the detection element.

In some embodiments a secondary projection apparatus and its associated electron detection device (not shown) are provided. The secondary projection apparatus and its associated electron detection device may be aligned with a secondary electron-optical axis of the secondary device. In some embodiments the beam separator is arranged to deflect the path of the secondary electron beams towards the secondary projection apparatus. The secondary projection apparatus subsequently focuses the path of secondary electron beams onto a plurality of detection regions of the electron detection device. The secondary projection apparatus and its associated electron detection device may register and generate an image of the target 308 using the secondary electrons or backscattered electrons (or signal particles).

Such a Wien filter, a secondary device and/or a secondary projection apparatus may be provided in a single beam assessment apparatus. Additionally and/or alternatively a detection device may be present downbeam of the objective lens, for example facing the sample during operation. In an alternative arrangement a detector device is position along the path of the charged particle beam towards the sample. Such an arrangement does not have a Wien filter, a secondary device and a secondary projection apparatus. The detection device may be positioned at one or more positions along the path of the charged particle beam path towards the sample, such as facing the sample during operation, for example around the path of the charged particle beam. Such a detector device may have an aperture and may be annular. The different detector devices may be positioned along the path of the charged particle to detect signal particles having different characteristics. The electron-optical elements along the path of the charged particle beam, which may include one or more electrostatic plates with an aperture for the path of the charged particle beam, may be arranged and controlled to focus the signal particles of different respective characteristics to a respective detector device at different positions along the path of charged particle beams. Such electrostatic plates may be arranged in series of two or more adjoining plates along the path of the charged particle beam.

Any element or collection of elements may be replaceable or field replaceable within the charged particle-optical device. Such an element or collection of elements may be comprised in a module of the charged particle system 40. Such replaceability means that such a module may be removed and replaced with a replacement module without substantially dismantling the rest of the charged particle system 40, for example even in the field. The one or more electron-optical components in the charged particle-optical device, especially those that operate on sub-beams or generate sub-beams, such as aperture arrays and manipulator arrays may comprise one or more plates each of which may be an electrode or may comprise one or more electrodes per aperture of the array. In some embodiments, the manipulators such as the lenses and deflectors 322_1, 322_2, and 322_3 are controllable, passively, actively, as a whole array, individually or in groups within an array, so as to control the beamlets of charged particles projected towards the target 308.

As shown in **FIG. 4** the charged particle system 40 comprises a vacuum system comprising a plurality of chambers. The chambers are defined by the interior surfaces of exterior walls 351 and interior walls (not shown) of the vacuum system.

Certain components may be comprised in a separable or removable module, such as the different features of the source module 320. The electron-optical components may be a series of component arrays with electrically isolating supports which comprise material susceptible to contamination for example outgassing. Such materials may be susceptible to water absorption such as plastic and/or ceramic. Associated with the electron-optical components of the source module may be electronics which may be mounted on a support such as a PCB or potting to contain electric fields. Communications and power may electrically connect the electronics, the electron-optical components and an external controller such as through a feedthrough in a wall 351 of the vacuum chamber. A cable such as a flex cable may provide such electrical connections. The module may have actuators to position the electron-optical components relative to the source 201 (or at least a path of the charged particle beams).

Components of a charged particle system 40 that may be used in the present disclosure are further described below in relation to **FIG. 10,** which is a schematic diagram of a charged particle system 40. The charged particle system 40 of **FIG. 10** may correspond to the charged particle system 40 (which may also be referred to as an apparatus or a tool) mentioned above. Features of the earlier described embodiments are the same, unless stated to the contrary. Features, functions, benefits and advantages of the present disclosure described in reference to earlier embodiments apply to some embodiments here unless statements are made to the contrary. Similarly features, benefits function and advantages described with reference to some embodiments described with reference to **FIG. 10,** unless stated to the contrary apply to the earlier mentioned embodiments.

The schematic diagram of an example charged particle device, as shown in **FIG. 10** has an objective lens array assembly. The objective lens array assembly comprises the objective lens array 241. The objective lens array 241 comprises a plurality of objective lenses. Each objective lens comprises at least two electrodes (e.g., two or three electrodes) connected to respective potential sources. The objective lens array 241 may comprise two or more (e.g., three) plate electrode arrays connected to respective potential sources. Each objective lens formed by the plate electrode arrays may be a micro-lens operating on a different sub-beam or group of sub-beams in the multi-beam. Each plate defines a plurality of apertures (which may also be referred to as holes). The position of each aperture in a plate corresponds to the position of a corresponding aperture (or corresponding hole) in the other plate (or plates). The corresponding apertures define the objective lenses and each set of corresponding holes therefore operates in use on the same sub-beam or group of sub-beams in the multi-beam. Each objective lens projects a respective sub-beam of the multi-beam onto a sample 208.

The objective lens array assembly further comprises the control lens array 250. The control lenses pre-focus the sub-beams (e.g., apply a focusing action to the sub-beams prior to the sub-beams reaching the objective lens array 241). The pre-focusing may reduce divergence of the sub-beams or increase a rate of convergence of the sub-beams. The control lens array and the objective lens array operate together to provide a combined focal length. Combined operation without an intermediate focus may reduce the risk of aberrations. In some embodiments, the control lens array may be considered to be part of the objective lens array.

In the arrangement of **FIG. 10,** the objective lens array assembly comprises the scan-deflector array 260. The scan-deflector array 260 comprises a plurality of scan deflectors. Each scan deflector scans a respective sub-beam over, or across, the sample 208. The scan-deflector array 260 may thus comprise a scan deflector for each sub-beam. Each scan deflector may deflect rays in the sub-beam in one direction (e.g., parallel to a single axis, such as an X axis) or in two directions (e.g., relative to two non-parallel axes, such as X and Y axes). The deflection is such as to cause the sub-beam to be scanned across the sample 208 in the one or two directions (i.e., one dimensionally or two dimensionally). In some embodiments, the scanning deflectors described in EP2425444, which document is hereby incorporated by reference in its entirety specifically in relation to scan deflectors, may be used to implement the scan-deflector array 260. The scan-deflector array 260 is positioned between the objective lens array 241 and the control lens array 250. In the example shown, the scan-deflector array 260 is provided instead of a macro scan deflector, such as an electrostatic scan deflector (not shown). A scan-deflector array 260 may be more spatially compact than a macro scan deflector.

The objective lens array assembly may comprise a detector 240.

(Alternatively the detector maybe comprised in the charged particle device 41 without having to be present in the objective lens array assembly). The detector 240 may comprise detector elements (e.g., sensor elements such as capture electrodes). The detector 240 may comprise any appropriate type of detector. For example, the detector elements may be charged based detector configured to detect charge detected with respect to time e.g., as current, scintillators or using semiconductor devices such as PIN elements. The detector 240 may be a direct current detector or an indirect current detector.

The detector 240 may be positioned between the objective lens array 241 and the sample 208. The detector 240 is configured to be the most downbeam feature of the electron-optical device, for example proximate the sample 208. The detector 240 may be very close to the sample 208, for example less than 5mm, preferably between 200 and 10 $\mu$m.

The detector 240 may be positioned in the device so as to face the sample 208. Alternatively or additionally, the detector 240 may be positioned elsewhere in the charged particle system 40 such that part of the charged particle device 41 that faces the sample 208 is other than, and thus is not, a detector; such as an electrode of the objective lens arrangement. In such an arrangement another element of the electron-optical device may face the sample during operation, for example an electrode plate of the objective lens. In all these arrangements there is a most downbeam element of the electron-optical system, such as detector 240, most proximate to the sample. The most downbeam surface of the most downbeam element may face the sample.

A bottom surface of the detector 240 (or a facing surface of the detector 240 that may face a sample 208 in use) may comprise a substrate on which are provided a plurality of detector elements. Each detector element may surround a beam aperture. The beam apertures may be formed by etching through the substrate. In the arrangement the beam apertures are in a hexagonal close packed array, or alternatively in a rectangular array. The detector elements may be arranged in a rectangular array or a hexagonal array.

In cross section of the detector, the detector elements form the bottommost, i.e., most close to the sample 208, surface of the detector 240. Between the detector elements and the main body of the substrate a logic layer may be provided. At least part of the signal processing system may be incorporated into the logic layer. A wiring layer is provided on the backside of, or within, the substrate and connected to the logic layer by through-substrate vias. The wiring layer can include control lines, data lines and power lines. A printed circuit board and/or other semiconductor chips may be provided on, for example connected to, the backside of detector 240.

The detector 240 may be implemented by integrating a CMOS chip detector into an electrode of the objective lens array 241, such as the bottom electrode of the objective lens array 241. Integration of a detector 240 into the objective lens array 241 or other component of the charged particle device 41 allows for the detection of electrons emitted in relation to multiple respective sub-beams. The CMOS chip may embody the detector it may be orientated to face the sample. In some embodiments, detector elements to capture the secondary charged particles are formed in the surface metal layer of the CMOS device. The detector elements can be formed in other layers. Power and control signals of the CMOS may be connected to the CMOS by the through-silicon vias. A passive silicon substrate with holes shields the CMOS chip from high E-fields, for example providing robustness.

In order to maximize the detection efficiency, it is desirable to make the surface of the detector elements as large as possible, so that substantially all the area of the objective lens array 240 (excepting the apertures) is occupied by detector elements. Additionally or alternatively, each detector element has a diameter substantially equal to an array pitch (i.e., of the pitch of the apertures of the aperture array in the electrodes of the objective lens assembly 241). The diameter of each detector element may be less than approximately 600 $\mu$m, and preferably between approximately 50 $\mu$m and 500 $\mu$m. The pitch may be selected depending on the intended distance between the sample 208 and the detector 240. In some embodiments the outer shape of the detector element is a circle, but this can be made a square to maximize the detection area. The diameter of the through-substrate via can be minimized. A typical size of the electron beam is in the order of 5 to 15 $\mu$m.

In some embodiments, a single detector element surrounds each beam aperture. In some embodiments, a plurality of detector elements are provided around each beam aperture.

**FIG. 11** schematically depicts a charged particle system 40 according to some embodiments. Features that are the same as those described above are given the same reference numerals. For conciseness, such features are not described in detail with reference to **FIG. 11.** For example, the source 201, the condenser lenses 231, the macro collimator 270, the objective lens array 241 and the sample 208 may be as described above. Features, functions, benefits and advantages of the present disclosure described in reference to earlier embodiments apply to some embodiments referring to **FIG. 11** unless statements are made to the contrary. Similarly features, benefits function and advantages described with reference to some embodiments described with reference to **FIG. 11** unless stated to the contrary apply to the earlier mentioned embodiments.

As described above, in some embodiments, the detector 240 is between the objective lens array 241 and the sample 208. The detector 240 may face the sample 208. Alternatively, as shown in **FIG. 11,** in some embodiments, the objective lens array 241, which comprises the plurality of objective lenses, is between the detector 240 and the sample 208. The detector 240 may have all the features of the earlier described embodiments for example with reference to **FIG. 10,** except as herein described.

In some embodiments a deflector array 95 is between the detector 240 and the objective lens array 241. In some embodiments the deflector array 95 comprises a Wien filter (or even a Wien filter array) so that deflector array may be referred to as a beam separator. The deflector array 95 is configured to provide a magnetic field to disentangle the charged particles projected to the sample 208 from the secondary electrons from the sample 208.

In some embodiments, the detector 240 is configured to detect signal particles by reference to the energy of the charged particle, i.e., dependent on a band gap. Such a detector may be a semiconductor-based detector such as a PIN detector or a scintillator, which may be optically connected to a photonic converter or photon to electron converter). Such a detector 240 may be called an indirect current detector. The secondary electrons emitted from the sample 208 gain energy from the fields between the electrodes. The secondary electrodes have sufficient energy once they reach the detector 240.

The control lens array 250 may be present, for example in the same module as an objective lens array 241, i.e., forming an objective lens array assembly or, in one type of terminology, as part of the objective lens array, or it may be in a separate module.

In some embodiments for example of any of the embodiments described with reference to and shown in **FIGs. 10** and **11,** one or more aberration correctors are provided that reduce one or more aberrations in the sub-beams. The one or more aberration correctors may be provided in any of the embodiments, e.g., as part of the charged particle-optical device, and/or as part of an optical lens array assembly, and/or as part of an assessment system, and/or as part of an electron-optical arrangement. In some embodiments, each of at least a subset of the aberration correctors is positioned in, or directly adjacent to, a respective one of the intermediate foci (e.g., in or adjacent to the intermediate image plane). The sub-beams have a smallest cross-sectional area in or near a focal plane such as the intermediate plane. This provides more space for aberration correctors than is available elsewhere, i.e., upbeam or downbeam of the intermediate plane (or than would be available in alternative arrangements that do not have an intermediate image plane). In some embodiments, aberration correctors positioned in, or directly adjacent to, the intermediate foci (or intermediate image plane) comprise correctors to correct for the source 201 appearing to be at different positions for different beams. Correctors can be used to correct macroscopic aberrations resulting from the source that prevent a good alignment between each sub-beam and a corresponding objective lens. In some embodiments, aberration correctors are integrated with, or directly adjacent to, the objective lens array 241. In some embodiments, these aberration correctors reduce one or more of the following: field curvature; focus error; and astigmatism. The aberration correctors may be CMOS based individual programmable deflectors as disclosed in EP2702595A1 or an array of multipole deflectors as disclosed EP2715768A2, of which the descriptions of the beamlet manipulators in both documents are hereby incorporated by reference.

Additionally or alternatively, one or more scanning deflectors (not shown) may be integrated with, or directly adjacent to, the objective lens array 241 for scanning the sub-beams 211, 212, 213 over the sample 208. In some embodiments, the scanning deflectors described in US 2010/0276606, which document is hereby incorporated by reference in its entirety, may be used.

As shown in **FIG. 2** (when read in context of the charged particle devices 41 as depicted in and described with respect to **FIGs. 3, 4, 10,** and **11),** in some embodiments, the projection assembly 60 optionally comprises an optical system 63. In some embodiments, the projection system 60 comprises a light source 61. The light source 61 is configured to emit the light beam 62. As mentioned above, the projection assembly 60 is used to illuminate a light beam 62 on the sample 208 so as to control the accumulated charges due to effects such as photoconductivity, photoelectric, or thermal effects; and thus regulate the accumulated charges on the sample. In an arrangement, the light may be directed between the facing surface of the electron-optical device and the sample surface, for example by reflecting off such surfaces until it is incident on the sample at the same locations as the primary beams. In an arrangement the path of the light from the light source 61 may be at least partly through the charged particle device 41. For example, the path of the light may enter the charged particle device upbeam of the objective lens array 240 and be reflected by a reflecting surface 65 within the charged particle device 41 towards the sample for example through the apertures defined in the plates defining the objective lens array and other charged particle-optical elements of the charged particle device. In some embodiments, the light source may be proximate to the source 201, for example around the source 201 and or adjacent to the source so that the path of the light towards the sample passes through all the elements of the charged particle device 41. In some embodiments, the path of the light is through light guides from the light source to the objective lens array for example as disclosed in EP 22204243.4 filed on 27 October 2022, which is hereby incorporated by reference at least so far as the disclosure of optical light guides for outcoupling light towards a sample. Additionally or alternatively the light may be outcoupled proximate or from apertures defined in the surface of the element facing the sample.

As shown in **FIG. 11** the charged particle system 40 comprises a vacuum system comprising a plurality of chambers. The chambers are defined by the interior surfaces of exterior walls 351 and interior walls (not shown) of the vacuum system.

In some embodiments, charged particle system 40 may comprise a plurality of sources 201 (not shown). Features, functions, benefits and advantages of the present disclosure described in reference to earlier embodiments apply to some embodiments, which will be described from now, unless statements are made to the contrary. Similarly features, benefits function and advantages of some embodiments here, unless stated to the contrary apply to the earlier mentioned embodiments. In some embodiments, a charged particle system comprising a plurality of charged particle devices 41 each with a respective source 201. (In a different embodiment the charged particle devices 41 may comprise a respective source 201). The charged particle device 41 may be any of the charged particle devices shown and depicted with reference to **FIGs. 3, 10,** and **11.** In some embodiments, each charged particle device of the plurality of charged particle devices comprised in a charged particle system can has a similar arrangement to that shown in and described with reference to **FIG. 3** in having a collimator array and a scan deflector array proximate and for example integrated with the objective lens array and the control lens array.

In this arrangement, each source 201 is configured to emit a respective beam of charged particles. The charged particle system in this arrangement comprises a respective charged particle device 41 for each respective source 201. The charged particle systems comprise walls between chambers of adjoining electron-optical devices. In particular, in this arrangement, the walls between chambers of adjoining electron-optical devices are interior walls. The interior walls may define different chambers for respective charged particle devices 41. This arrangement may have one or more electrical components which may be in respective modules as described with reference to the charged particles systems of **FIGs. 3, 4, 10,** and **11.**

In some embodiments the charged particle device 41 may comprise alternative and/or additional components on the charged particle path, such as lenses and other components some of which have been described earlier with reference to **FIG. 1** and **4.** A detector is provided to detect charged particles emitted by the sample. The detector may be integrated into the objective lens. The detector may be on the bottom surface of the objective lens so as to face a sample in use. The detector may comprise an array, for example of detector elements, which may correspond to the array of the beamlets of the multi-beam arrangement. The detectors (or detector elements) in the detector array may generate detection signals that may be associated with the pixels of a generated image.

In some embodiments, a charged particle system may include a plurality of example charged particle-optical devices 41. Each charged particle device 41 may comprise a source 201 and one or more electron-optical assemblies. Alternatively, the electron-optical apparatus that comprises the charged particle device 41 may comprise the source 201. The charged particle device 41 may comprise an upper beam limiter 252, a collimator element array 271, a control lens array 250, a scan deflector array 260, an objective lens array 241, a beam shaping limiter 242 and a detector array. The source 201 provides a beam of charged particles (e.g., electrons). These components may take the form as described with reference to the electron device 41 shown and described with reference to **FIGs. 3, 4,** and **10.**

The collimator element array 271 is provided downbeam of the upper beam limiter 252. Each collimator element collimates a respective sub-beam. The collimator element array 271 may be formed using types of processing techniques so as to be spatially compact. In some embodiments, the collimator element array 271 is the first deflecting or focusing electron-optical array element in the beam path downbeam of the source 201.

In some embodiments, a charged particle-optical device array is provided. The array may comprise a plurality of any of the charged particle-optical devices described herein. Each of the charged particle-optical devices focuses respective multi-beams simultaneously onto different regions of the same sample.

Any number of charged particle-optical devices may be used in the array. Each charged particle-optical device in the array may be configured in any of the ways described herein when referring to a single charged particle-optical device. Details of such an arrangement is described in EPA 20184161.6 filed 6 July 2020, which, with respect to how the objective lens is incorporated and adapted for use in the multi-device arrangement, is hereby incorporated by reference.

In some embodiments, a charged particle system 40 provides an arrangement of four beam areas arranged in two rows of two beam areas. The charged particle system 40 comprises a plurality of charged particle beam sources 201. The charged particle system 40 comprises four sources 201 (two of which are visible). The walls defining the vacuum chamber comprising the module may be compromised in a module such as source array module. Such a source array module may be replaceable. The different charged particle devices 41 may comprise a collimator 235, a condenser lens array 231, and an objective lens array 241. The collimator is configured to collimate the beams of the beam grid, for example as collimated beams towards the sample, from a diverging array of beams from the condenser lens array 231. As mentioned, the charged particle device comprises electron-optical components for example as described with reference to and shown in **FIGs. 3, 10,** and **11** or variations thereof.

Although this disclosure described embodiments referring to multi-beam systems, it will be appreciated that the present disclosure is applicable to a single beam system. Such a single beam system may comprise a source, a condenser lens, a detector, a scan deflector and an objective lens with other electron-optical elements such as correctors. A single beam system may have similar electron-optical components and architectures as the charged particle assessment system shown in and described with reference to **FIG. 4,** except, for example with a single beam and without components for generating and/or operating on different beams separately such as the source converter for a plurality of beams.

To realize high resolution or throughput, assessment systems of at least one primary beam directed towards a sample, e.g., single beam or multibeam SEM systems, generally operate with high voltage power supplies, e.g., ranging from several hundred volts to tens of kilovolts (kV). For example, electron beams are emitted, accelerated, focused, or deflected towards a sample by a high voltage power supply via an electron source and an electron-optical column including various electron-optical components such as lenses, electrodes, filters, deflectors, etc., some of which may comprise conductive plates or planar electrodes in which one or more apertures are defined. Such electron-optical components may be set to have a potential difference relative to each other or relative to nearby isolating features. Such nearby isolating features may comprise features of the mechanical structure in which the electron-optical components are comprised, e.g., the wall of the vacuum chamber. Such a potential difference may be a large or high potential difference, for example ranging from a few tens of volts to a couple hundred volts, and up to tens of kilovolts in magnitude, which may be referred to a high voltage potential difference, or just high voltage (HV). Electrical discharge such as electrical discharge events may occur between components within the assessment system. Such electrical discharge events may comprise electrical discharge (for example as discharge events) of a relatively small magnitude, which may be referred to as a 'micro-discharge.' Discharge events may readily occur in the current assessment systems operating with components at large potential differences. Usually discharge events may occur when electron-optical components of the system are in an unfavorable environment. Such environments may be contaminated or at a higher pressure than intended. Such environments may have contamination such as particles and molecular deposits for example of hydrocarbons. Such environments have a higher pressure than desired pressure, for example due to contamination. Such electrical discharge events for example inside such environments may cause undesirable effects in the charged particle system. For example, electrical discharge events (for example one event or several events such as repeated discharge events over an extended period of time) may damage to a component such as an electron-optical component, e.g., a plate such as an electrode, which may operate at a high potential difference. In some embodiments, damage may be accumulated during many damage events such as micro-discharge events over an extended period of time. As a consequence of electrical discharge, a particle may separate (e.g., breakaway) from the component. A particle generation event may be a consequence of a damage event. Such damage events and particle generation events may degrade inspection accuracy and even exacerbate the likelihood of further electrical discharge events. With cumulation of damage events and particle generation events, the likelihood of a further discharge event (which may lead to a further damage event and thus to a further particle generation event) may increase. As consequence of a discharge event may be catastrophic failure of the charged particle system, a failure of, for example, the electron-optical components of the charged particle system at least temporarily may not cause any immediate impact on the system performance. Similarly, for a discharge event such as a micro-event, there is no immediate impact on performance of the system such as electron-optical performance. During catastrophic failure of the charged particle system, there may be a loss of at least one function of the system. For a discharge event without immediate impact on electron-optical performance, cumulation of damage from such discharge events may later on result in impact on the electron-optical performance or even catastrophic failure. Therefore, it is desirable to find a cause and solution for such electrical discharge events as early as possible to improve availability of the charged particle system during operation and to improve the inspection throughput and overall semiconductor manufacturing yield.

Several ways are known to detect electrical discharges in the current systems, for example: (1) monitoring power supply parameters of the charged particle system; and (2) use of a pick-up coil. To monitor operation parameters of power supplies (or power supply units) of the charged particle system for example the voltage and/or current of each power supply that is supplied to charged particle system is monitored. The monitoring the power supplied in terms of the current and/or voltage of the respective supply monitors for a voltage drop or a current peak. A discharge event occurs when the voltage drops or the current peaks for example when there is a spike in current or voltage. Such a voltage drop is observed typically when the current supplied by the power supply is limited (for example through current limiting by a current limiting event) to protect the power supply in response to a leak current such as a discharge event. A difference in the detected current for a monitored power supply (for example a current difference) is indicative of the size of the current leak (e.g., discharge). Detection of a relatively large leak, for example, in the range of micro-ampere ($\mu$ A) or milliampere (mA) range is technically feasible using this approach in that, for example, commercially available power supplies have sufficiently sensitive current meters and voltmeters. However, detection of a current leak for example having a current of relatively small order of magnitude such as micro-discharge requires a current measuring capability that may sense a current in the nanoampere (nA) range. Current and voltage detection devices such as a current meter or a voltage meter having such sensitivity is commercially unavailable for such power supplies, which supply and apply large potential differences such as use in the charged particle system. Monitoring such power supply parameters is unfeasible for detecting discharge events with a small size of current for example micro-discharge events.

In contrast, in the use of a pick-up coil, the pick-up coil is placed around for example a cable conducting a high voltage current. The pick-up coil is sensitive to a high frequency discharge current so the pick-up coil can detect current leaks of a small current such as characteristic of a micro-discharge event. The approach of using a pick-up coil may successfully detect both discharge events over a large range of discharged events, for example large and small discharge events including micro-discharge events. The pickup coil is placed along the cable between the power supply to which the cable is connected and the electron-optical component to which the cable supplies power. In practice, in order to ensure reliable detection of discharge events, such pick-up coils are placed close to the components to which a high voltage is supplied and/or applied. Usually, the cable close to the components, such as within the vacuum chamber, does not conduct a return current from the components. If the pick-up coil were to be positioned along a cable conducting current in both directions (including to the component and the return current) the signal present in both currents would cancel out. Detecting discharge events in the cable may be achieved by having the pick-up coil positioned along the cable functioning as a singular power line (i.e., without the return current). However, such pickup coils are large and bulky. Having the pick-up coils adjacent to a cable supplying power to the different component in the charged particle system is hard to achieve because of space constraints in the charged particle system. Moreover, pickup coils may be sensitive to certain frequency ranges. Such a pick-up coil may be insensitive to disturbances and perturbations (e.g., representative of drops, peaks, spikes, or pulses in current or voltage) outside the frequency range. Frequency signals are indicative of alternating current behavior so pick-up coils are unsuitable for electrical discharges having direct current characteristics (e.g., DC-like currents). That is, the use of pick-up coils will not detect a discharge event when there is a current leak that has characteristics of direct current e.g., a continuous stream of electrical discharge events (which may comprise or be entirely of micro-discharge events).

An electrical discharge event generates a light pulse (i.e., as a number of photons), which may be observed as a flash of light or a glow. Such a light pulse may be detected using a camera. Such a camera is large relative to the available volume in the charged particle system. It is impractical to install a camera that may capture a light pulse generated by an electrical discharge event. Even if such a camera is used to detect light pulses through viewports such as through the wall 351 of the vacuum chamber within the charged particle system in view of the space constraints, the camera may not efficiently capture photons derived from the different electrical discharge events. A method of detecting electrical discharge events that may be sufficiently sensitive to detect even micro-discharge event and/or electrical discharge events having direct current characteristics that can operate within the available volume of the charged particle system despite the space constraints.

According to some embodiments of the present disclosure, electrical discharge events within the charged particle system may be detected using an optical waveguide or a plurality of the waveguides. In some embodiments, the optical waveguide may guide a light pulse from the location where it is generated (e.g., by discharge within a charged particle system) to a light sensitive detector (or photo detector). In some embodiments, the photo detector may be positioned remote from the location where the light pulse is generated. In some embodiments, the photo detector is positioned outside the vacuum chamber. In some embodiments, a light pulse generated by a discharge event may be transmitted with low, for example minimum, light attenuation from the location of the discharge to the remotely positioned photo detector. For transmission with low light attention, an optical waveguide having a low light attenuation rate may be used. The optical wave guide may extend between the position of the photo detector and a location within the vacuum chamber where a light pulse is likely to be generated. The optical waveguide may have an end close to the component such as an electron-optical component with which an electrical discharge event is likely to occur, for example within the vacuum chamber. According to some embodiments of the present disclosure, the optical waveguide may be capable of coupling in light, for example, the optical waveguide may collect light generated by electrical discharge events. Such an optical waveguide may be used to detect electrical discharge events within the charged particle system.

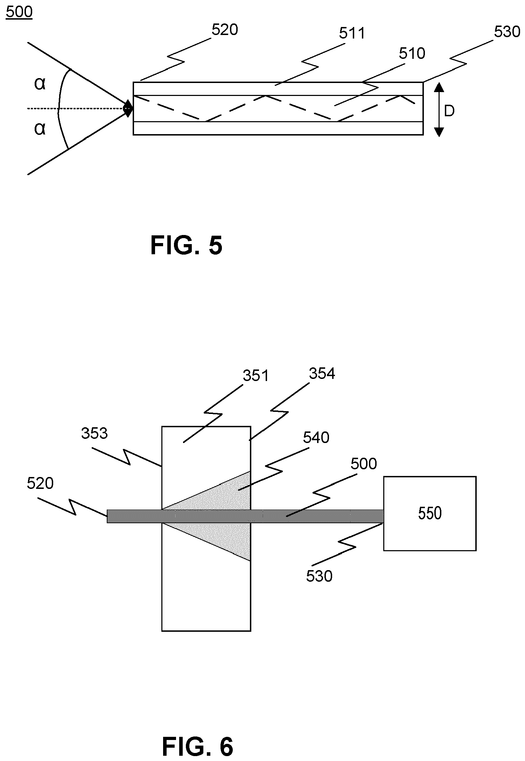

**FIG. 5** is a schematic diagram of an optical waveguide 500. The depicted optical waveguide 500 may be consistent with some embodiments of the present disclosure. As shown in **FIG. 5,** the optical waveguide 500 may be an optical fiber. The optical fiber may comprise a core 510 and a cladding layer 511. The cladding layer 511 may be on the core 510; for example, the cladding layer 511 may surround the core 510. In some embodiments, the optical waveguide 500 has a numeral aperture NA equal to or greater than 0.20. For the arrangement shown in **FIG. 5,** the numerical aperture NA of the optical waveguide 500 may be represented as

$$NA = n \sin \alpha = \sqrt{n_1^2 - n_2^2}$$

, where n represents the absolute refractive index, which is the refractive index of the ambient environment to the optical waveguide (so for vacuum n is one), $\alpha$ represents half of an acceptance angle AA, $n_1$ represents a refractive index of core 510, and $n_2$ represents a refractive index of cladding layer 511. Thus, the acceptance angle AA of optical waveguide 500 may be represented as $AA = 2\alpha$. In this context, the acceptance angle AA may be considered to be the angle of an acceptance cone (or opening angle) of an end of the optical waveguide. Within the acceptance cone, light may be accepted into the core of the optical waveguide (or coupled into the optical waveguide) for transmission along the optical waveguide. The optical waveguide 500 may detect light within the field of view of the optical waveguide 550. The field of view of the optical waveguide may be determined by the acceptance angle AA. The larger acceptance angle AA is, the wider that the viewing angle of optical waveguide 500 is. A wider acceptance angle may relatively increase the coverage of the optical waveguide 500 may have, for example within the vacuum chamber, for collecting (or coupling in) light pulses induced or generated by electrical discharge events. Such an increase in the coverage of the light collecting of the optical waveguide 500 may increase the acceptance cone and may increase the light collection coverage range over the surface of the components of the optical waveguide 500 within the charged particle system 500. In some embodiments, the optical waveguide 500 that has numerical aperture NA equal to or greater than 0.2. Such a large numerical aperture may help to enable the optical waveguide 500 to have a large acceptance angle AA for a suitably large light collection coverage range within charged particle system 40. In some embodiments, the optical waveguide 500 may comprise a material, having a numerical aperture NA equal to or greater than 0.3. Increasing the numerical aperture AA of the optical waveguide 500 may increase (or enlarge) the light collection coverage range of the optical waveguide 500. A numeral aperture NA equal or greater than 0.3 may be preferred because it increases the acceptance angle of the end of the optical waveguide sufficiently for example to capture more photons and increase the chance of detecting discharge events of lower current such as micro discharge events. The greater the numerical aperture NA is, the more light that the optical waveguide may couple for guiding along its length. In some embodiments, the optical waveguide 500 has numerical aperture NA equal to or greater than 0.35, 0.40, 0.45, 0.50 or even higher may be utilized. In some embodiments, the larger the difference between the refractive index between the cladding the core is, the larger the numerical aperture NA and then the larger the acceptance cone become. There may be a plurality of waveguides 500. With a natural number of waveguides within charged particle system 40, the light collection coverage may be achieved within the charged particle system 40, for example the vacuum chamber of the charged particle system 40. With the plurality of waveguides, the light collection coverage range within the charged particle system may be optimally increased.

Such an optical waveguide has two ends. The two ends are at opposite ends of the optical waveguide 500. The optical waveguide has a light collecting 520 end (e.g., a first end) and a sensor end 530 (e.g., a second end). In some embodiments, the optical waveguide 500 is installed such that the light collecting end 520, is positioned close to a component within the charged particle system 40, to which component may be applied a high potential difference. A sensor end 530 of the optical waveguide 500 is located remote from the component, for example outside of the vacuum chamber, or even outside of the charged particle system 40. In some embodiments, the optical waveguide 500 may have a low light attenuation value. According to some embodiments, the light attention value of the optical waveguide 500 is equal to or less than 10dB/km, which may be referred to as the attenuation characteristic (i.e., a property of the material of the optical fiber). An optical waveguide having a light attention value of the attention characteristic may enable efficient transmission of the light through the optical waveguide 500. An optical waveguide of the light attention value may enable detection of an electrical discharge event for example by passage of light to the sensor end 520 through transmission via the optical waveguide 500 from the light collecting end 520.

In some embodiments, the optical waveguide 500 may be configured to have a relatively small diameter D, e.g., about 250 $\mu$m, for example in the range of 50 to 500 $\mu$m. The small diameter of optical waveguide 500 may offer a greater degree of freedom of movement for positioning the optical waveguide 500, for example during installment of the optical waveguide 500 within the charged particle system. The large degree of freedom of movement of the optical waveguide 500 during installation is helpful in view of the limited space within the charged particle system 40. In some embodiments, the optical waveguide 500 that has a relatively small diameter D in view of its length may be flexible. The optical waveguide may have a small flex bend radius. Such a small flex bend radius enables the optical waveguide 500 to be routed flexibly within the charged particle system 40, which may be especially useful with the limited space within the charged particle system 40. In some embodiments, the relatively small diameter D of the optical waveguide 500 may facilitate installment of the optical waveguide 500 via the wall 351 of the vacuum chamber. The wall 351 may comprise the vacuum feedthrough to enable the optical waveguide 500 to pass through the wall 351 to ensure the integrity of the vacuum (for example the vacuum condition) for example within the vacuum chamber.

In some embodiments, the optical waveguide 500 may be an optical fiber. In some embodiments, the optical waveguide 500 may comprise a hard cladded silica fiber. In some embodiments, the optical waveguide 500 may comprise glass, which has a low attenuation rate for visible light. In some embodiments, the refractive index of the core 510 is higher than the refractive index of the cladding layer 511. The larger the difference is, the larger the acceptance angle (e.g., the acceptance cone or the light acceptance angle) is. In some embodiments, optical waveguide 500 may be a multi-mode optical fiber. Such a multiple mode-optical fiber may have multiple light transmission modes. The multiple light transmission modes of the fiber may occur simultaneously. Such a multiple mode-optical fiber thus supports multiple light transmission modes simultaneously. In the optical fiber that is a multi-mode optical fiber, light from different discharge events may be transmitted via optical waveguide 500 simultaneously. That is a multi-mode optical fiber can transmit multiple modes. The number of modes (and the number of signals) that such an optical fiber may transmit may increases with the dimension, e.g., diameter of the core of the optical fiber. Light (e.g., light pulses) from the different discharge events may be transmitted by the optical waveguide for example between the light of the different discharge events. In some embodiments, optical waveguide 500 may comprise a hard cladded silica fiber. In some embodiments, many more electrical discharge events may be transmitted by the multi-mode fiber when the optical fiber has a greater number of modes. That is, in some embodiments, optical waveguide 500 may detect two different discharge events simultaneously. Further, such higher mode multi-mode optical fibers may have a larger core and may have larger acceptance angle with increased and improved coverage of the interior (or the volume) for example of the vacuum chamber of the charged particle system 40.

**FIG. 6** is a schematic diagram of a cross sectional view of the optical waveguide 500 installed in the charged particle system 40 so the optical waveguide 500 passes through the wall of for example the vacuum chamber. The depicted arrangement may be consistent with some embodiments of the present disclosure. **FIG. 6** illustrates that optical waveguide 500 is routed into charged particle system 40 via the vacuum wall 351.

As shown in **FIG. 6,** optical waveguide 500 may pass via a hole 540 defined in the vacuum wall 351. Having the optical waveguide 500 to have a small diameter D, facilitates installment of the optical waveguide 500 through the hole 540 through vacuum wall 351 with a corresponding small diameter. Having the optical waveguide 500 and the hole to have corresponding small diameters may help to ensure the vacuum within the vacuum chamber is maintained, for example that the risk of disruption to the vacuum (e.g., the vacuum condition) within the charged particle system 40 is reduced if not substantially eliminated. As shown in **FIG. 6,** the dimensions of hole 540 (for example the cross-sectional diameter such as the diameter of the hole) in the wall 351 substantially matches the cross section of optical waveguide 500 at least on an interior surface (for example a first surface 353) of the wall for example facing the inside of the charged particle system 40 such as the vacuum chamber (for example when the wall 351 at least in part defines the vacuum chamber). In some embodiments, the dimensions of hole 540 (for example the cross-sectional diameter such as the diameter of the hole) in the wall 351 has a larger size than a cross section of optical waveguide 500 on an exterior surface (for example a second surface 354) of the wall for example facing the outside of the charged particle system 40 such as the vacuum chamber of the wall. Having diameter of the hole larger at the first surface 353 than the second surface 354 may facilitate mounting of optical waveguide 500 through vacuum wall 351 from the outside into the inside of the vacuum chamber or more generally the charged particle system 40. The first end 520 of the optical waveguide 500 may be positioned within the vacuum chamber or at least the charged particle system 40, while second end 530 of the optical waveguide 500 is positioned outside of the vacuum chamber or even outside of the charged particle system 40. According to some embodiments, the optical waveguide 500 may transmit light, such as the light pulses, from inside of the vacuum chamber or otherwise the charged particle system 40 to a photo detector 550 for example positioned remotely from the vacuum chamber or even the charged particle system 40 with a low, for example a minimum, loss of light collected (for example light in-coupled), e.g., by the first end of the optical waveguide 500. In some embodiments, after the optical waveguide 500 is secured via vacuum wall 351, the hole 540 may be sealed with a sealant which may cure to harden during fabrication. The volume defined between the hole 540 and a portion of the optical waveguide 500 through the hole between the first surface 353 and the second surface 354 may be filled with the sealant. The sealant may be of a hydro-carbon material such as epoxy, acrylic, etc. The sealant may hermetically seal to secure the optical waveguide 500 to the wall 351. The sealant may be part of a vacuum feedthrough described in more detail herein later. In some embodiments, the optical waveguide 500 may be mounted via the sealant, or otherwise secured, to the vacuum wall 351 such that the first end 520 of optical waveguide 500 may be directed towards locations within the charged particle system 40 such as the vacuum chamber where the electrical discharge events are more likely to occur for example so that such locations are within the light collection coverage range of the first end of the optical waveguide 500. Thus, the first end of the optical guide 500 is positioned to observe for locations within the charged particle system 40 in which potential electrical discharge events are likely.

According to some embodiments of the present disclosure, the sensor end 530 is optically connected to an optical sensor (or photo detector 550) that may convert light into an electrical signal. The electrical signal may be a detection pulse such as current or voltage. In some embodiments, the photo detector 550 may comprise a detection device such as a semiconductor diode, a photomultiplier tube, an avalanche photodiode or the like. The detection device is sensitive to photonic radiation e.g., light, such as visible, infrared or ultraviolet electro-magnetic radiation. The detection device may emit the electrical pulse on incidence of photonic radiation that may be indicative of a discharge event. Each detection pulse may correspond to a light pulse which may correspond to a discharge event. According to some embodiments of the present disclosure, the photo detector 550 may comprise an electric pulse monitoring element for monitoring of detection pulses. The sensor detector 550 may detect a discharge event on detection by the electric current monitoring element registering the corresponding detection current. In some embodiments, the photo detector 550 may determine an intensity of such an electrical discharge event based on the measurement of a magnitude of the detection pulse. As shown in **FIG. 6,** the photo detector 550 may be positioned outside of the vacuum chamber for example due to the volume constraint within the vacuum chamber. In some embodiments, the photo detector 550 may be positioned inside of the vacuum chamber. The photo detector 550 may be positioned apart, for example, at a distance from the components from or to which an electrical discharge event is likely to occur.

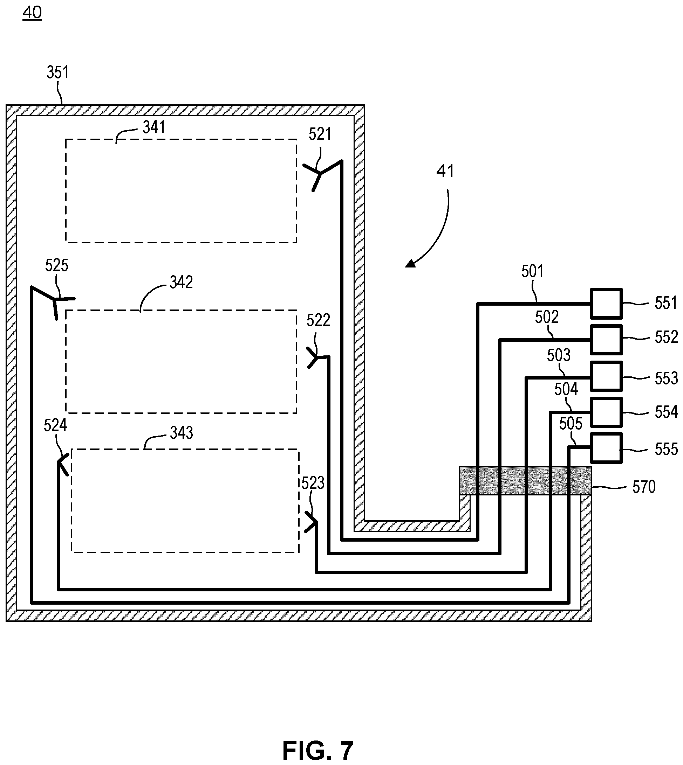

**FIG. 7** is a schematic diagram of a plurality of the optical waveguides (collectively optical waveguide 500) installed within a charged particle system via a vacuum feedthrough 570. The arrangement depicted in **FIG. 7** may be consistent with some embodiments of the present disclosure. According to some embodiments of the present disclosure, the multiple optical waveguides 500 may be routed to monitor different regions, e.g., different components of the charged particle system 40. The different regions covered by the light collection coverage ranges of the first ends of the different optical waveguides 500 may at least partially overlap and/or monitor different components within the charged particle device 40 such as the vacuum chamber. Such components may be, for example, the walls 351 of the vacuum chamber, the sample holder 207, the shielding plate 280, the source 201, and one or more of the electron-optical components of the electron-optical column such as lenses such as lenses arrays, collimators such as collimator arrays, deflectors such as deflector arrays and detectors such as detector arrays. During operation, such an arrangement at least one of the optical waveguides may be routed to monitor a sample supported on the sample support. Such electrical discharge events may occur between two components within the vacuum chamber. At least one of the two components is conductive. The likelihood of a discharge event is higher when the electrical field is high (e.g., several kV per millimeter). For example, the likelihood of a discharge event is high when the two components having a high potential difference are close together. Therefore, all surfaces within the vacuum chamber such as the electron-optical components comprised in source 201 and the electron-optical column have possibility of being a surface with which an electrical discharge event may occur. Such electron-optical components may be for example within source section 341 and electron column section 342 of any of the arrangements shown and described with reference to in **FIGs. 3, 4,** and **10,** and **11.** The electrical fields derived from high potential differences may be in the volume of the vacuum chamber in which the sample holder 207 is located, for example the sample holder may be set to a high potential difference relative to another component within the vacuum chamber. To enable the sample holder 207 (and in operation a sample 208 when supported by the sample holder 207) to be set to a high potential difference may also be implemented to be comprised of conductors or a conductive coating for example as a surface of the sample holder 207. In an arrangement, the sample holder (and in use a sample 208 when supported by the sample holder 207) may be proximate to another component of the stage section 343. The other component proximate to the sample holder 207 may be set to a high potential difference for example relative to a ground potential of the charged particle system 40. Electrical discharge events may occur around sample holder 207 or sample 208, between sample holder 207 and/or the sample 208 (when supported by the sample holder 207), for example between sample holder 207 and/or the sample 208 and the other proximate component such as a proximate region of the wall 351 of the vacuum chamber. Such discharges occurring proximate to sample 208 may damage the sample 208. Therefore, there is a need to avoid having electrical discharge events around sample holder 207. In some arrangements, the proximate component set at a high potential may be set at a low potential difference relative to the sample holder, for example such a proximate component may be the shielding plate 280 as shown in and described with reference to **FIG. 3, 4, 10,** and **11.** The purposes of the shielding plate 280 may be to ensure that the electric field proximate to the sample surface is uniform and to reduce the risk of electrical discharge events involving the sample surface and to avoid if not prevent such electrical discharge events associated with a surface of the sample support or the sample. However there may still a risk of electrical discharge interventions in view of for example: the relative motion between the sample support and the shielding plate 280; both the sample support surface and the facing surface of the shielding plate 280 are set at high potential differences with respect to a ground of the charged particle system; and the risk of large height variations in the surface topology of a sample surface; and/or the risk of the presence of contamination such as particles for inducing electrical discharge events.

As shown in **FIG. 7,** a plurality of the optical waveguides 501-505 (collectively optical waveguide 500) are routed into a vacuum chamber via a vacuum feedthrough 570 for example through the wall 351 of the vacuum chamber. The vacuum feedthrough 570 may be considered to be part of the part 351. In some embodiments, the vacuum feedthrough 570 may be configured to maintain the integrity of the vacuum for example within the vacuum chamber. The vacuum feedthrough enables the passage of the optical waveguides 501-505 from outside of the vacuum chamber to the volume inside the vacuum chamber for example while ensuring the integrity of the vacuum; the vacuum feedthrough seals the passage of the optical waveguides 501-505 such as respective holes or a common hole through the wall 351 of the vacuum chamber. It is noted that there may be a common feedthrough for the plurality of waveguides 501-505. In a variation there may be more than one vacuum feedthrough for example for one or more of the optical waveguides 501-505. As shown in **FIG. 7,** the optical waveguides 501-505 are routed within the electron-optical system 40 for example within the vacuum chamber to monitor different parts, such as different components, of the charged particle system 40, for example different regions in which the different components are located. For example, a first optical waveguide 501 is routed monitor a source section 341. In **FIG. 7,** the outer bounds of an acceptance cone are represented by diverging lines at first end 521 of the first optical waveguide 501. The acceptance cone is the field of view of the first end within which the first end may couple in incoming light e.g., a light pulse representative of discharge event. The diverging lines at the first end 521 schematically represent the outer bounds of the acceptance cone covering any light generation such as from electrical discharge events within the source section 341. A second optical waveguide 502 and a fifth optical waveguide 505 are routed respectively to monitor the electron column section 342. The respective first ends (for example as indicated by diverging lines) of the first end 522 of the second optical waveguide 502 and the first end 525 of the fifth optical wave guide 505 to monitor (e.g., observe) different regions within the electron column section 342. The outer bounds of the acceptance cones of the first end 522 of the second optical waveguide 502 may have light collection coverage ranges that may in-couple light pulses from different portions of the same components or from different components and may have different views of a light pulse from the sample electrical discharge event. While **FIG. 7** illustrates the first end 522 of the second optical waveguide 502 and first end 525 of the fifth optical waveguide 505 may be located at different positions along the beam path to monitor different regions of the volume within electron column section 342 along the beam path. The first end 522 of the second optical waveguide 502 and the first end 525 of the fifth optical waveguide 505 may be located at the same position along the beam path for example to view different regions of the electron column section 342 at the sample general position along the beam path for example to monitor components at the same position along the beam path for example from different viewpoints. Similarly, the third optical waveguide guide 503 and the fourth optical waveguide 504 are routed to monitor at different regions within the stage section 343. In some embodiments, an optical waveguide may be placed to view at least part of sample holder 207 or sample 208, for example the optical waveguide may be placed so that the first end 523 of the third optical waveguide 503 may have an acceptable cone with outer bounds with a light collection coverage range that may in-couple light pulses in the stage section 343 for example in a region around the sample holder 207 and/or a sample 208 when present and supported by the sample holder 207.

In some embodiments, the source section 341 may have a high probability of electrical discharge events because of the higher potential differences applied to components within the source section 341. The source section 341 may have a relatively high concentration of electron-optical components such as emitter, anode, etc. compared to another of the sections of the charged particle system 40. In some embodiments, one or more optical waveguides 500 may be routed to view source section 341 from various angles. For example, the first ends 520 of such waveguides 500 may be positioned so as to have acceptance angles to couple in light from different positions around the source section 341 for example to couple in the light from different angles. It may be appreciated that the number of optical waveguides and routes illustrated and depicted in **FIG. 7** are merely for illustration and are not intended to limit the present disclosure. It will be appreciated that any number of optical waveguides and routes may be utilized.

According to some embodiments of the present disclosure, the optical waveguide 500 may be routed within the vacuum chamber close to a target element or position that is located within a limited space. The route of the optical waveguide may include tight angles and bends. The optical waveguide may be routed through and around the components within the vacuum chamber with such route because the optical waveguide 500 has a small bending radius and is a thickness of a small dimensions (e.g., small diameter) e.g., the optical waveguide 500 is very thin for example, having a diameter that is of the order of magnitude of a hundred micron for example in the range of a couple hundred micron, e.g., 50 to 500 µm. In some embodiments, the optical waveguide 500 has a large field of view (i.e., acceptance angle AA). Thus, the number of optical waveguides to observe relevant region of the charged particle system 40, for example of one of the sections of the charged particle system 40 such as the source section, the electron-column section and the stage section, may be decreased. In some embodiments, the optical waveguide 500 is a multi-mode type of optical waveguide. A single optical waveguide 500 may detect multiple electrical discharge events simultaneously. As shown in **FIG. 7,** each optical waveguide 501-505 may be associated with the corresponding photo detector (which may be for the arrangement shown in **FIG. 7** a first photo detector 551, a second photo detector 552, a third photo detector 553, a fourth photo detector 554 and a fifth photo detector to 555; which are collectively photo detector 550). In some embodiments, the plurality of optical waveguides 501-505 may be associated with a single photo detector 550 that comprises a plurality of detector circuits. The different detector circuits of the plurality of detector circuits may correspond to the plurality of the optical waveguides 501-505, respectively. In some embodiments, the photo detectors 551 to 555 may be positioned inside of the vacuum chamber at a distance from the components, which comprise the electron-optical components. In such embodiments, the vacuum feedthrough 570 may be used to route wires to and from photo detectors 551 to 555 to the outside of the vacuum chamber. Such wires may transmit power to the photo detectors 551 to 555 and transmit detection signals from photo detectors 551 to 555 such as to a processor which may be separate or a part of the controller 50.

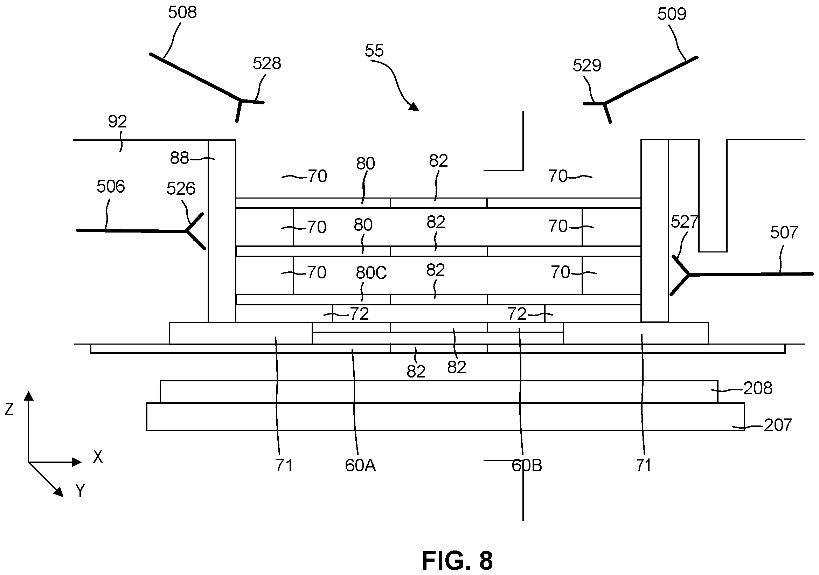

**FIG. 8** is a schematic diagram of a plurality of the optical waveguides installed within a charged particle system, consistent with some embodiments of the present disclosure. In some embodiments, a plurality of charged particle-optical components are provided in electron-optical column 55 such as a part of the electron-optical column such as a module of the electron-optical column 55. Such charged particle optical components are planar, which may be in the form of plates 80 and may be used to operate as an electrode or may comprise a plurality of electrodes for example one or more electrodes for a respective beam of the beam grid. In the orientation shown in **FIG. 8,** a plurality of the primary beams for example arranged in the beam grid may have respective paths in a direction from the source 201 to the sample 208. The path of the beam grid may have a direction corresponding to a charged particle-optical axis of the electron-optical column 55. In the depicted orientation, purely for convenience of the present description, the paths of the primary beams of the beam grid may be in a direction in the depiction of **FIG. 8** from the top of the page and down of the page. The apertures are defined in each plate 80 within a beam area of the plates of charged particle-optical components. The plate 80 may serve as an electrode for all beams of the beams so that the plate may operate as single electrode. In a different arrangement, the plate may have one or more controllable electrode at each aperture defined in the plate. Even if the electrodes are separately controllable so that the potential differences may be individually applied to the or each electrode at each aperture, the plate may have an applied potential, which may be of a high potential difference for example relevant to another component in the charged particle apparatus 40.

As shown in **FIG. 8,** in some embodiments, the electron-optical column 55 comprises one or more spacers 70-72. The spacers 70-72 are configured to mechanically support the plates 60. For example, each of the spacers 70-72 may support one or more adjoining plates. The spacers 70, 72 may interleave adjoining plates 60. Some or all of the spacers 70-72 may be configured to electrically isolate adjoining plates 80 from each other. One or more of the plates may comprise dielectric material. In an arrangement, the spacer may be planar for example with two major surfaces and for example with an aperture defined therethrough for the passage of the beams of the beam grid. The surface of the aperture between the two major surfaces (such as the major surface) may be referred to as a rim.

As shown in **FIG. 8** and only for the purposes for aiding present description, the beam areas 82 may be located away from, such as spaced apart from the rim for example to reduce the risk of electrical interaction between the spacer and the beams along the path of the beam grid. The distance may be larger than required for avoiding unwanted electrostatic influence of the beams of the beam grid because contamination of surfaces of the spacer such as the rim may induce an electrical discharge event with a component with a relative potential difference such as a plate 60. In an arrangement, the beam areas of the different plates may be aligned with each other. In an arrangement, the beam areas may be located generally centrally in a major surface of the respective plate. At least one of the plates 80 may operate as a lens with respect to a primary beam path through apertures in the respective plates. The plurality of the apertures on respective plates may operate as an array of lenses, a lens array or more generally an array of electron-optical elements. The lens array provided by a plurality of the plates 80 may be the objective lens array 241 and/or the control lens array 250. The plurality of charged particle-optical components may additionally or alternatively define the condenser lens array 310, the collimator array 235, an individual beam corrector (not shown), a deflector 260, or a Wien filter array (which may comprise a plate of electrostatic deflectors and a plate of an array of magnetic deflector arrays). The electron-optical column 55 may take any of the forms described above with reference to **FIG. 1** to **4**, 10, and 11 or other arrangements known in the art.

In some embodiments, at least two of the plates 80 are configured to be set at different potentials. In some embodiments, one or more plates 80 are set to a ground potential. In some embodiments, the objective lens array (being an exemplary charged particle optical component) comprises at least one of the plates 80 (as an electrode) that is set at the ground potential. Alternatively or additionally, the electron-optical component is a detector substrate comprising such a plate set to a ground potential. The detector substrate may comprise a detector array. The detector array may be configured to detect signal particles emitted from the sample 208. As described above, the detector array may comprise an array of detector elements. The detector array may comprise an integrated circuit for example at least partly within the detector substrate. The detector array may take any of the forms described above with reference to **FIG. 2** to **4.** The detector array may form part of the charge detector 240.

Setting at least one of the plates 80 of the charged particle-optical components, for example of the arrangement shown and described in the charged particle column 55 of **FIG. 8,** at the ground potential facilitates provision of a low impedance electrical path from that plate 80 (or plates) of the charged particle-optical components to a stable electrical potential. This may reduce the risk of damage to the respective charged particle-optical components from electric discharge events. Alternatively or additionally, setting at least one of the plates 80 of the charged particle-optical components at the ground potential may provide electrostatic shielding. Such electrostatic shielding may reduce the risk of damage to sensitive components for example fragile components, such as a detector array. The shielding may shield such sensitive components from electric fields present beyond, for example on an opposite side, of the shielding.

In some embodiments, at least two of the plate components 80 are configured to face each other. In some embodiments, one of the at least two plates 80 that are configured to face each other is a facing electrode 60B. The facing electrode 60B may be an electrode (such as a constituent plate 60) of the objective lens. The facing electrode 60B defines a continuous conductive surface in which are defined multiple apertures. Each aperture may surround the path of a respective beam of the multi-beam. The continuous conductive surface electrostatically shields a plate 60A, which may comprise a charged particle optical component which may be referred to as a shielded charged particle-optical component. The facing electrode 60B may face the shielded charged particle-optical component. The shielded charged particle-optical component, for example comprises of the plate 60A, is shielded from electric fields present up beam of the facing electrode 60B, such as on an opposite side of the facing electrode 60B. Shielding the charged particle-optical component that comprises plate 60A from the electric fields may reduce a risk of, or prevents, damage to the shielded charged particle-optical component from the electric fields. The facing electrode 60B may be set at ground potential. The shielding charged particle optical component may comprise wiring such as an integrated circuit which may be sensitive to external electrostatic field. The shielded charged particle optical component may be comprised by the detector substrate and may comprise the detector array.

In some embodiments, the charged particle apparatus comprises a down-beam spacer 71. The down-beam spacer 71 may be electrically connected to an adjoining plate 80, 60B. In some embodiments, the down beam spacer 71 is electrically connected to the plate 60A of the shielded charged particle-optical component. The down beam spacer may at least partly comprise an electrically conductive material such as at least the surface of the plate 60A for example as a coating. In some embodiments, the down beam spacer 71 is set to the ground potential for example which may the same potential as the adjoining plate, 80, 60B and/or the plate 60A the shielded charged particle-optical component. The electrical connection from the down beam spacer 71 to the plate 60A of the shielded charged particle-optical component may thus set the shielded charged particle-optical component to the ground potential. In the examples shown an electrically insulating barrier 88 is provided between a support structure 92 for mechanically supporting the depicted plates and the charged particle-optical components 80 of the electron-optical column 55. The insulating barrier 88 may electrically isolate the plates 60, 60A, 60B of the charged particle-optical components, which may need to be set to non-ground potentials, from the support structure 92.

In some embodiments, the electron-optical column 55 is field replaceable. The electron-optical column 55 may be removed from and/or inserted into the charged particle system 40 without requiring any substantial dismantling of other parts of the charged particle system 40. That is the electron-optical column 55 may be removable from and/or insertable into the charged particle system 40. A part of the electron-optical column 55 such as a module, such as the portion shown in and described with reference to **FIG. 8.**

As illustrated referring to **FIG. 8,** at least part of a module 55 of the electron-optical column 55 includes multiple plates, which may operate as electrodes such as for lensing the beams of the beam grid. At least parts of the plates 80, 60A, 60B may have potential differences for example of a high potential difference with respect to each other and surfaces of other components and elements in the immediate environment. The plates and the surrounding surfaces of other components may be closely spaced together, which may generate high electric fields. Under such an environment, electrical discharge events may occur between surfaces between which there may be a high potential difference. Such surfaces liable to electrical discharge events may include any surface of the charged particle optical components, such as the constituent plates 80, 60A, or 60B, which may operate as electrodes during operation of charged particle system 40 and any uncovered surfaces of the spacers 70, 71, 72 such as the inner surface of rim. According to some embodiments of the present disclosure, there may be one or more optical waveguides 506-509 that may be routed to monitor the different charged particle-optical components such as plates 80, 60A, or 60B and spacers 70, 71, 72. As shown in **FIG. 8,** a first end 526 of a sixth optical waveguide 506 and a first end 527 of a seventh optical waveguide 507 are placed around the electron-optical column 55. The first ends 526, 527 may have acceptance cones with opening angles as shown by the respective diverging lines. The two first ends 526, 527 may be positioned at different positions along the path of the beam grid for example in some embodiments in which the general direction of the beam path of the beam grid is in the opposite direction from a hypothetical z axis, at different heights along the z-axis. The two first ends 526, 527 are directed to monitor different parts of electron-optical column 55, for example the two first ends are positioned and angled to have an acceptance angle for a light collection coverage range that may in-couple light pulses from different regions of the electron-optical column 55. In some embodiments, insulating barrier 88 may be configured to be transparent at least optically to the wavelengths of light comprised in the light pulses. Positioning the open ends radially outside the insulating barrier 88 for example with respect to the path of the beam grid may enable the optical waveguide 506 or 507 to in-couple, for example to collect, light through insulating barrier 88. Additionally or alternatively the spacers 70, 71, 72 may be optically transparent. An eighth optical waveguides 508 and a ninth optical waveguide 509 are routed to observe an up beam surface such as a top side of the depicted charged particle optical components of the electron-optical column 55, which may be a module; so the optical waveguides may monitor the up beam surface of the module or may monitor the module from an upbeam position relative to the module. The first end 528 of the eight optical waveguide 508 and the first end of the ninth optical waveguide 509 may be positioned at different azimuthal positions relative to the path of the beam grid. The two first ends 528, 529 of the eight optical waveguide 508 and of the ninth optical waveguide 509 may have a larger field of view together than individually so together they may have for a light collection coverage range over the upbeam surface of the electron-optical column that may in-couple light pulses more effectively than the just one of the first ends of the eight optical waveguide 508 and of the ninth optical waveguide 509. In some embodiments, one or more the optical waveguides 506-509 may be routed to cover various region of and around the electron-optical column for example within the vacuum chamber where discharges might happen. According to some embodiments, on which component a discharge has occurred may be determined by have optical waveguides 506-509 positioned and/or angled so that the different waveguides 506-509, such as the first ends of the respective optical waveguides 506-509 to monitor, for example to observe, different components as illustrated in **FIG. 8,** for light pulses indicative of electrical discharge events.

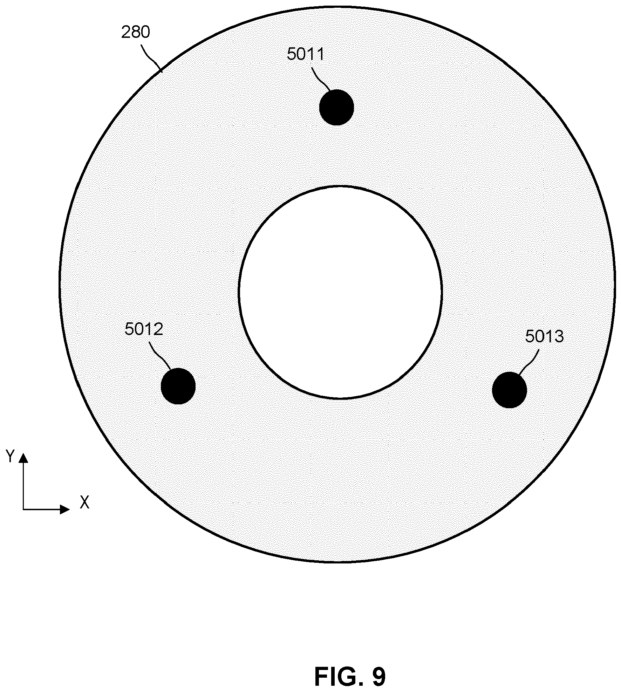

In some embodiments, one or more of the different optical waveguides 500 may be routed to observe at least part of the stage section 343 for example at least part of the sample holder 207, the sample 208 (when present) and the shielding plate 280. **FIG. 9** is a schematic diagram of a plurality of optical waveguides installed on a shielding plate 280. The shielding plate 280 consistent with some embodiments of the present disclosure for example as shown and described with reference to **FIG. 3, 4, 10,** and **11;** the shielding plate may be across the path of the beam of a single beam system or the beam grid of a charged particle system with a plurality of primary beams directed towards the sample 208. As shown in **FIG. 9,** one or more optical waveguides 5011-5013 may be routed in shielding plate 280, for example through a respective aperture defined in the shielding plate for passage of a respective optical waveguide 5011-5013. Each waveguide 5011-5013 may monitor for light pulses indicative of an electrical discharge event in or around the electron optical column (e.g., electron optical column 55 of **FIG. 8**) from a different angle (e.g., from the bottom) than the side and from upbeam of the electron optical column 55. In some embodiments, the one or more optical waveguides 5011-5013 may be routed in shielding plate 280 to monitor the region around the sample 208 (when present on the sample holder) and/or the sample holder 207 for potential discharges from an upbeam position. Such discharge events may occur in the region between the shielding plate 280 and the sample support. In some embodiments, monitoring and then observing electrical discharge events by one or more of the optical waveguides 5011-5013 positioned in a shielding plate (such as shielding plate 280) across the beam path enables the determination of a position of the electrical discharge event with a region upbeam of the sample support, for example in a plane (e.g., a x-y plane) across the beam path (e.g., z-axis). In some embodiments, three optical waveguides 5011-5013 may be routed in a shielding plate (e.g., shielding plate 280), which enables to determine a discharge position on an x-y plane using a triangulation method. In a different arrangement there may be one or more optical waveguides with first ends in the sample support for example around the sample. Such optical waveguides may be used instead of the waveguides in the shielding plate 280 or with the shielding plate 280 for monitoring and the observation of any electrical discharge events in the region between the shielding plate 280 and the sample support and sample 208 (when present). The observation of a light pulse via such an optical waveguide may be used in such triangulation methods.

Such a triangulation method may incorporate time information for example the relative time of detection of light pulses via the different optical waveguides for example thus each having different relative location to the position of the discharge event that may be the source of the different light pulses detected by via the different optical waveguides. Such triangulation (for example incorporating time information) may be used to determine the location of the discharge event for example with respect to the shielding plate 280 (for example in the arrangement of **FIG 9**) or the module 55 of the electron optical column (for example in the arrangement of **FIG 8**) or more generally within the charged particle system 40 such as within the walls of the vacuum chamber of the charged particle system 40 (for example in the arrangement shown in and described with reference to **FIG. 7**). Such discharge event in such a calculation may be taken as the source for each of the light pulses detected by the different optical waveguides.

In this text reference is made to electron-optical plates in which one or more apertures are defined. Such a plate may be manufactured using processing suitable for manufacturing microelectromechanical systems (MEMS). Such a charged particle-optical component or device may be referred to as a MEMS. MEMS are miniaturized mechanical and electromechanical elements that are made using microfabrication techniques. The pre-bending deflector array 323 may be a MEMS. In some embodiments, the charged particle system 40 comprises apertures, lenses and deflectors which may be formed as MEMS such as the condenser lens array, the control lens array, the objective lens array, the collimator array, scan deflector arrays, corrector arrays and even features of the detector array. Further such electron optical components such as the condenser lenses, objective lenses and/or detector may be formed as MEMS or CMOS devices.

One or more electric power sources may be provided as a power supply to the electron-optical element of each and every component and element pf the different charged particle systems herein disclosed. Potentials may be applied to the different electrodes of the different electrostatic components. Current may be applied to the referenced magnetic components. Such components and elements include, for example: the macro-condenser lens, the source, the scan deflector, the detector, the electrodes of the control lenses of the control lens array 250, the objective lenses of the objective lens array 241, the elements of the collimator array, the lenses of the condenser lens array, the scan deflector array and corrector elements.

References to upper and lower, up and down, above and below, top and bottom etc. should be understood as referring to directions generally parallel to the (typically but not always vertical) upbeam and downbeam directions of charged particle beams for example relative to the path of the beams such as the path of the beam grid and/or impinging on the sample 208. Thus, references to upbeam and downbeam are intended to refer to directions in respect of the beam path independently of any present gravitational field.

The descriptions above are intended to be illustrative, not limiting. Thus, it will be apparent to one skilled in the art that modifications may be made as described without departing from the scope of the claims and clauses set out below.

The embodiments may further be described using the following clauses:

Clause 1. An electron-optical apparatus for projecting a charged particle beam towards a sample, the apparatus comprising: a stage configured to support a sample; a vacuum chamber configured to maintain a vacuum; an electron-optical device configured to generate a charged particle beam and direct the charged particle beam towards the sample; and an optical detection system configured to detect electromagnetic radiation within the apparatus, the optical detection system comprising a sensor and an optical waveguide having a first end positioned so as to detect electromagnetic radiation within the apparatus.

Clause 2. The apparatus of clause 1, wherein the electromagnetic radiation is derived from electrical discharges within the electron-optical device.

Clause 3. The apparatus of clause 1 or 2, wherein the optical waveguide has a numerical aperture equal to or greater than 0.30.

Clause 4. The apparatus of any one of clauses 1-3, wherein the optical waveguide has a light attenuation rate equal to or less than 10dB/km.

Clause 5. The apparatus of any one of clauses 1-4, wherein the optical waveguide is an optical fiber.

Clause 6. The apparatus of clause 5, wherein the optical fiber comprises a core and a cladding layer.

Clause 7. The apparatus of clause 5 or 6, wherein the refractive index of the core is higher than the refractive index of the cladding.

Clause 8. The apparatus of any one of clauses 1-7, wherein the optical waveguide is a multi-mode waveguide such as a multimode optical waveguide (e.g. the optical fiber is a multi-mode fiber e.g. a multi-mode optical fiber).

Clause 9. The apparatus of any one of clauses 5-8, wherein the optical fiber comprises a hard cladded silica fiber.

Clause 10. The apparatus of any one of clauses 1-9, wherein the sensor is remote from the electron-optical device.

Clause 11. The apparatus of clause 10, wherein the sensor comprises a photo detector.

Clause 12. The apparatus of clause 10 or 11, wherein the sensor is positioned outside of the apparatus.

Clause 13. The apparatus of any one of clauses 1-12, wherein the optical waveguide is configured to extend through a wall of the vacuum chamber.

Clause 14. The apparatus of clause 13, wherein the optical waveguide is configured to extend into the vacuum chamber via a vacuum feedthrough.

Clause 15. The apparatus of any one of clauses 1-14, wherein the electron-optical device comprises a plurality of electron-optical components, the plurality of electron-optical components comprising at least one of an electron-beam source, an objective lens, a control lens, a collimator, a deflector, a Wien filter, a charged particle detector, a coulomb aperture array, and a corrector.

Clause 16. The apparatus of clause 15, wherein the beam comprises a plurality of beams directed towards a sample, and wherein at least one of the electron-optical components is an element comprised in an array of such elements configured to operate on a beam of the plurality of beams.

Clause 17. The apparatus of clause 16, wherein the plurality of beams configured to be arranged in an array corresponding to the array of the elements.

Clause 18. The apparatus of clause 16 or 17, wherein at least one of the electron-optical components comprises an electron-optical plate in which a plurality of apertures are defined for different beams.

Clause 19. The apparatus of clause 18, wherein the electron-optical components comprise at least two electron-optical plates stacked along a beam path.

Clause 20. The apparatus of clause 18 or 19, wherein at least one of the electron-optical components comprises a spacer located between two adjoining plates.

Clause 21. The apparatus of any one of clauses 16 to 20, wherein the array is a source array configured to generate the plurality of beams, a condenser lens array, a collimator array, a corrector array, an objective lens array, a control lens array, a deflector array, a Wien filter array, or a detector array.

Clause 22. The apparatus of any one of clauses 1-21, wherein the first end of the optical waveguide is directed to an electron-optical element in the electron-optical device, the electron-optical element having a high-voltage potential during operation.

Clause 23. The apparatus of any one of clauses 1-22, wherein the electron-optical device may be electrostatic, magnetic, or both.

Clause 24. The apparatus of any one of clauses 1-23, wherein the optical waveguide is positioned such that the first end is positioned along a path of the beam.

Clause 25. The apparatus of clause 24, wherein the optical detection system comprises a second optical waveguide.

Clause 26. The apparatus of clause 25, wherein a first end of the second optical waveguide is positioned at a different position along the path of the beam from the first end of the optical waveguide.

Clause 27. The apparatus of clause 25 or 26, wherein the first end of the second optical waveguide is positioned at the same position along the path of the beam as the first end of the optical waveguide.

Clause 28. The apparatus of any one of clauses 1-27, wherein the first end is positioned in a plane across a path of the beam.

Clause 29. The apparatus of clause 28, wherein the optical detection system comprises at least three optical waveguides of which first ends positioned at different locations on a plane across the path of the beam.

Clause 30. The apparatus of any one of clauses 1-29, wherein the first end of the optical waveguide is positioned such that a part of the stage is positioned within a field of view of the first end.

Clause 31. The apparatus of any one of clauses 1-27, wherein the optical detection system comprises one or more optical waveguides of which first ends positioned in a plate, which is coplanar with the stage.

Clause 32. The apparatus of any one of clauses 1-31, wherein the first end of the optical waveguide is positioned on the stage.

Clause 33. The apparatus of any one of clauses 1-32, further comprising a power source configured to apply a potential difference between two or more components of the electron-optical device and to supply a current to at least one of the two or more components of the electron-optical device.

Clause 34. The apparatus of any one of clauses 1-33, further comprising a feedthrough configured to accommodate passage of the optical waveguide through a wall of the vacuum chamber.

Clause 35. A method of detecting electromagnetic radiation in an electron-optical apparatus for projecting a charged particle beam towards a sample, the electron-optical apparatus comprising a stage configured to support the sample; a vacuum chamber configured to maintain a vacuum; and an electron-optical device configured to generate a charged-particle beam and direct the charged particle beam towards the sample, the method comprising: accepting electromagnetic radiation using a first end of an optical waveguide, the first end of the optical waveguide is positioned inside of the apparatus; transmitting the accepted electromagnetic radiation through the optical waveguide from the first end to a sensor; and detect the accepted electromagnetic radiation using the sensor, wherein the electron-magnetic radiation is indicative of a discharge event within the apparatus.

Clause 36. The method of clause 35, wherein the electromagnetic radiation is derived from electrical discharges within the electron-optical device.

Clause 37. The method of clause 35 or 36, wherein the optical waveguide has a numerical aperture equal to or greater than 0.30.

Clause 38. The method of any one of clauses 35-37, wherein the optical waveguide has a light attenuation rate equal to or less than 10dB/km.

Clause 39. The method of any one of clauses 35-38, wherein the optical waveguide is an optical fiber.

Clause 40. The method of clause 39, wherein the optical fiber comprises a core and a cladding layer.

Clause 41. The method of clause 39 or 40, wherein the refractive index of the core is higher than the refractive index of the cladding.

Clause 42. The method of any one of clauses 35-41, wherein the optical waveguide is a multi-mode waveguide (e.g. the optical fiber is a multi-mode fiber).

Clause 43. The method of any one of clauses 39-41, wherein the optical fiber comprises a hard cladded silica fiber.

Clause 44. The method of any one of clauses 35-43, wherein the sensor is remote from the electron-optical device.

Clause 45. The method of clause 44, wherein the sensor comprises a photo detector.

Clause 46. The method of clause 44 or 45, wherein the sensor is positioned outside of the apparatus.

Clause 47. The method of any one of clauses 35-46, wherein the optical waveguide extends through a wall of the vacuum chamber.

Clause 48. The method of clause 47, wherein the optical waveguide extends into the vacuum chamber via a vacuum feedthrough.

Clause 49. The method of any one of clauses 35-48, wherein the electron-optical device comprises a plurality of electron-optical components, the plurality of electron-optical components comprising at least one of an electron-beam source, an objective lens, a control lens, a collimator, a deflector, a Wien filter, a charged particle detector, a coulomb aperture array, and a corrector.

Clause 50. The method of clause 49, wherein the beam comprises a plurality of beams directed towards a sample, and wherein at least one of the electron-optical components is an element comprised in an array of such elements configured to operate on a beam of the plurality of beams.

Clause 51. The method of clause 50, wherein the plurality of beams configured to be arranged in an array corresponding to the array of the elements.

Clause 52. The method of clause 50 or 51, wherein at least one of the electron-optical components comprises an electron-optical plate in which a plurality of apertures are defined for different beams.

Clause 53. The method of clause 52, wherein the electron-optical components comprise at least two electron-optical plates stacked along a beam path.

Clause 54. The method of clause 52 or 53, wherein at least one of the electron-optical components comprises a spacer located between two adjoining plates.

Clause 55. The method of any one of clauses 50 to 54, wherein the array is a source array configured to generate the plurality of beams, a condenser lens array, a collimator array, a corrector array, an objective lens array, a control lens array, a deflector array, a Wien filter array, or a detector array.

Clause 56. The method of any one of clauses 35-55, wherein the first end of the optical waveguide is directed to an electron-optical element in the electron-optical device, the electron-optical element having a high-voltage potential during operation.

Clause 57. The method of any one of clauses 35-56, wherein the electron-optical device may be electrostatic, magnetic, or both.

Clause 58. The method of any one of clauses 35-57, wherein the optical waveguide is positioned such that the first end is positioned along a path of the beam.

Clause 59. The method of clause 58, wherein accepting electromagnetic radiation using a first end of an optical waveguide further comprises: accepting electromagnetic radiation using a first end of a second optical waveguide.

Clause 60. The method of clause 59, wherein the first end of the second optical waveguide is positioned at a different position along the path of the beam from the first end of the optical waveguide.

Clause 61. The method of clause 59 or 60, wherein the first end of the second optical waveguide is positioned at the same position along the path of the beam as the first end of the optical waveguide.

Clause 62. The method of any one of clauses 35-61, wherein the first end is positioned in a plane across a path of the beam.

Clause 63. The method of any one of clauses 35-62, wherein accepting electromagnetic radiation using a first end of an optical waveguide further comprises: accepting electromagnetic radiation using at least three optical waveguides of which first ends positioned at different locations on a plane across the path of the beam. a first end of a second optical waveguide.

Clause 64. The method of any one of clauses 35-63, wherein the first end of the optical waveguide is positioned such that a part of the stage is positioned within a field of view of the first end.

Clause 65. The method of any one of clauses 35-64, wherein accepting electromagnetic radiation using a first end of an optical waveguide further comprises: accepting electromagnetic radiation using one or more optical waveguides of which first ends positioned in a plate, which is coplanar with the stage.

Clause 66. The method of any one of clauses 35-65, wherein the first end of the optical waveguide is positioned on the stage.

Clause 67. The method of any one of clauses 35-66, further comprising applying a potential difference between two or more components of the electron-optical device; and supplying a current to at least one of the two or more components of the electron-optical device.

Clause 68. The method of any one of clauses 35-67, wherein apparatus further comprises a feedthrough configured to accommodate passage of the optical waveguide through a wall of the vacuum chamber.

Clause 69. The apparatus of clause 1 or 2, wherein the optical waveguide has a numerical aperture equal to or greater than 0.20.

Clause 70. The apparatus of clause 15, wherein electron-beam source comprises an emitter and one or more electrodes.

Clause 71. The apparatus of clause 20, wherein the spacer is located between two adjoining plates and optionally configured to electrically isolate the adjoining plates.

Clause 72. The apparatus of clause 27, wherein the first end of the second optical waveguide is positioned at the same position along the path of the beam as the first end of the optical waveguide so that fields of view of the first end of the second optical waveguide and the first end of the optical waveguide covers different features of the electron-optical device.

Clause 73. The apparatus of clause 31, wherein the plate is positioned around a bottom of the electron-optical device.

Clause 74. The apparatus of clause 32, wherein the first end of the optical waveguide is positioned on the stage so that at least a part of a bottom of the electron-optical device is in a field of view of the first end of the optical waveguide.

While the present invention has been described in connection with various embodiments, other embodiments of the invention will be apparent to those skilled in the art from consideration of the specification and practice of the technology disclosed herein. It is intended that the specification and examples be considered as exemplary only, with a true scope and spirit of the invention being indicated by the following claims and clauses herein.

**Claims**

1. An electron-optical apparatus for projecting a charged particle beam towards a sample, the apparatus comprising:

   a stage configured to support a sample;
   a vacuum chamber configured to maintain a vacuum;
   an electron-optical device configured to generate a charged particle beam and direct the charged particle beam towards the sample; and
   an optical detection system configured to detect electromagnetic radiation within the apparatus, the optical detection system comprising a sensor and an optical waveguide having a first end positioned so as to detect electromagnetic radiation within the apparatus.

2. The apparatus of claim 1, wherein the electromagnetic radiation is derived from electrical discharges within the electron-optical device.

3. The apparatus of claim 1 or 2, wherein the optical waveguide has a numerical aperture equal to or greater than 0.30.

4. The apparatus of any one of claims 1-3, wherein the optical waveguide has a light attenuation rate equal to or less than 10dB/km.

5. The apparatus of any one of claims 1-4, wherein the optical waveguide is an optical fiber.

6. The apparatus of claim 5, wherein the optical fiber comprises a core and a cladding layer.

7. The apparatus of claim 5 or 6, wherein the refractive index of the core is higher than the refractive index of the cladding.

8. The apparatus of any one of claims 5-7, wherein the optical fiber comprises a hard cladded silica fiber.

9. The apparatus of any one of claims 1-8, wherein the optical waveguide is a multi-mode optical waveguide.

10. The apparatus of any one of claims 1-9, wherein the sensor is remote from the electron-optical device. and/or the sensor is positioned outside of the apparatus.

11. The apparatus of any one of claims 1-10, wherein the electron-optical device comprises a plurality of electron-optical components, the plurality of electron-optical components comprising at least one of an electron-beam source, an objective lens, a control lens, a collimator, a deflector, a Wien filter, a charged particle detector, a coulomb aperture array, and a corrector.

12. The apparatus of any one of claims 1-11, wherein the first end of the optical waveguide is directed to an electron-optical element in the electron-optical device, the electron-optical element having a high-voltage potential during operation.

13. The apparatus of any one of claims 1-12, wherein the optical waveguide is positioned such that the first end is positioned along a path of the beam.

14. The apparatus of any one of claims 1-13, wherein the optical detection system comprises one or more optical waveguides of which first ends positioned in a plate, which is coplanar with the stage.

**15.** A method of detecting electromagnetic radiation in an electron-optical apparatus for projecting a charged particle beam towards a sample, the electron-optical apparatus comprising a stage configured to support the sample; a vacuum chamber configured to maintain a vacuum; and an electron-optical device configured to generate a charged-particle beam and direct the charged particle beam towards the sample, the method comprising:

accepting electromagnetic radiation using a first end of an optical waveguide, the first end of the optical waveguide is positioned inside of the apparatus;
transmitting the accepted electromagnetic radiation through the optical waveguide from the first end to a sensor; and
detect the accepted electromagnetic radiation using the sensor,
wherein the electron-magnetic radiation is indicative of a discharge event within the apparatus.

**FIG. 1**

40

201

41

202

230

61    64    62    63

65

211, 212, 213

240

60

66

280

208

221, 222, 223

207

209

Z

X

FIG. 2

**FIG. 3**

**FIG. 4**

500

520    511    530
510
D

α
α

**FIG. 5**

351    354
353    540
520    500
550
530

**FIG. 6**

40

351

341 521

525

342 522

524 343

523

41

501
502
503
504
505

551
552
553
554
555

570

**FIG. 7**

FIG. 8

EP 4 576 157 A1

**FIG. 9**

**FIG. 10**

40

351

341

201

342    231                    231

270

41

240

95

241                    241

343    280          207    208

351

# FIG. 11

Europäisches
Patentamt

European
Patent Office

Office européen
des brevets

**EUROPEAN SEARCH REPORT**

Application Number

EP 23 21 8888

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2011/291010 A1 (KATANE JUNICHI [JP] ET AL) 1 December 2011 (2011-12-01) * abstract * * paragraph [0001] - paragraph [0207] * * figures 1, 9, 15 * | 1-15 | INV. H01J37/244 H01J37/28 |
| A | WO 2011/066061 A2 (CORNING INC [US]; MISHRA SNIGDHARAJ K [US]) 3 June 2011 (2011-06-03) * abstract * * paragraph [0001] - paragraph [0099] * | 4,8 | |
| A | US 2002/190219 A1 (MOONEY PAUL E [US]) 19 December 2002 (2002-12-19) * abstract * * paragraph [0001] - paragraph [0040] * | 3,6,7 | |
| X | US 2020/064199 A1 (MAGEL GREGORY A [US] ET AL) 27 February 2020 (2020-02-27) * abstract * * paragraph [0001] - paragraph [0067] * * figures 1, 3 * | 1,9,15 | |

TECHNICAL FIELDS
SEARCHED (IPC)

H01J

The present search report has been drawn up for all claims

| Place of search | Date of completion of the search | Examiner |
|---|---|---|
| Munich | 21 May 2024 | Bridi, Dorian |

CATEGORY OF CITED DOCUMENTS

X : particularly relevant if taken alone
Y : particularly relevant if combined with another
  document of the same category
A : technological background
O : non-written disclosure
P : intermediate document

T : theory or principle underlying the invention
E : earlier patent document, but published on, or
  after the filing date
D : document cited in the application
L : document cited for other reasons

................................................................

& : member of the same patent family, corresponding
  document

EPO FORM 1503 03.82 (P04C01)

## ANNEX TO THE EUROPEAN SEARCH REPORT
## ON EUROPEAN PATENT APPLICATION NO.

EP 23 21 8888

This annex lists the patent family members relating to the patent documents cited in the above-mentioned European search report.
The members are as contained in the European Patent Office EDP file on
The European Patent Office is in no way liable for these particulars which are merely given for the purpose of information.

21-05-2024

| Patent document cited in search report | Publication date | Patent family member(s) | Publication date |
|---|---|---|---|
| US 2011291010 A1 | 01-12-2011 | CN 102308357 A | 04-01-2012 |
| | | CN 103871811 A | 18-06-2014 |
| | | DE 112010000743 T5 | 14-08-2013 |
| | | JP 5352262 B2 | 27-11-2013 |
| | | JP 2010182550 A | 19-08-2010 |
| | | KR 20110112409 A | 12-10-2011 |
| | | KR 20130014609 A | 07-02-2013 |
| | | US 2011291010 A1 | 01-12-2011 |
| | | US 2013026363 A1 | 31-01-2013 |
| | | WO 2010089958 A1 | 12-08-2010 |
| WO 2011066061 A2 | 03-06-2011 | BR 112012012441 A2 | 10-10-2017 |
| | | CN 102667554 A | 12-09-2012 |
| | | EP 2504726 A2 | 03-10-2012 |
| | | JP 2013512463 A | 11-04-2013 |
| | | KR 20120102718 A | 18-09-2012 |
| | | RU 2012126122 A | 27-12-2013 |
| | | US 7876990 B1 | 25-01-2011 |
| | | WO 2011066061 A2 | 03-06-2011 |
| US 2002190219 A1 | 19-12-2002 | DE 60027740 T2 | 21-09-2006 |
| | | EP 1218919 A1 | 03-07-2002 |
| | | US 6455860 B1 | 24-09-2002 |
| | | US 2002190219 A1 | 19-12-2002 |
| | | WO 0124218 A1 | 05-04-2001 |
| US 2020064199 A1 | 27-02-2020 | NONE | |

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2020118784 A
- US 20200203116 A
- US 20190259570 A
- US 20190259564 A
- EP 1602121 A1
- EP 20156253
- EP 2425444 A
- EP 2702595 A1
- EP 2715768 A2
- US 20100276606 A
- EP 22204243
- EP 20184161 A